# EUROPEAN PATENT APPLICATION

(11) **EP 4 270 464 A1**
(43) Date of publication of application: **01.11.2023**
(21) Application number: 23169529.7
(22) Date of filing: 24.04.2023
(51) Int. Cl.: H01L 21/822, H01L 21/8238, H01L 27/06, H01L 27/092, H01L 29/66, H01L 29/775

(54) **3D-STACKED SEMICONDUCTOR DEVICE INCLUDING GATE STRUCTURE FORMED OF POLYCRYSTALLINE SILICON OR POLYCRYSTALLINE SILICON INCLUDING DOPANTS**

(30) Priority: 26.04.2022 US 202263334901 P; 26.04.2022 US 202263334986 P; 12.10.2022 US 202217964677
(71) Applicant: Samsung Electronics Co., Ltd., Suwon-si, Gyeonggi-do 16677 (KR)
(72) Inventor: YUN, Seungchan, San Jose, CA, 95134 (US); BAEK, Jaejik, San Jose, CA, 95134 (US); JO, Gunho, San Jose, CA, 95134 (US); HONG, Byounghak, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a multi-stack semiconductor device that includes: a substrate (105); a lower field-effect transistor in which a lower channel structure (110) is surrounded by a lower gate structure including a lower work-function metal layer (115F) and a lower gate electrode (115P); and an upper field-effect transistor in which an upper channel structure (120) is surrounded by an upper gate structure including an upper work-function metal layer (125F) and an upper gate electrode (125M), wherein the lower gate electrode comprises polycrystalline silicon (poly-Si) or poly-Si comprising a dopant, and the upper gate electrode comprises a metal or a metal compound.

## Description

### BACKGROUND

### 1. Field

Apparatuses and methods according to embodiments relate to a multi-stack semiconductor device including a lower nanosheet transistor and an upper nanosheet transistor in which a gate structure for the lower nanosheet transistor includes a polycrystalline silicon (poly-Si) structure.

### 2. Description of the Related Art

Growing demand for integrated circuits having high device density has introduced a three-dimensional (3D) multi-stack semiconductor device in which two or more field-effect transistors such as nanosheet transistors are vertically stacked. The nanosheet transistor is characterized by one or more nanosheet channel layers vertically stacked on a substrate and a gate structure surrounding the nanosheet channel layers. Thus, the nanosheet transistor is referred to as gate-all-around (GAA) transistor, multi-bridge channel field-effect transistor (MBCFET).

In a multi-stack semiconductor device including two vertically stacked nanosheet transistors, one or more nanosheet channel layers of each nanosheet transistor function as a channel structure of the nanosheet transistor, and these channel layers are surrounded by a gate structure. The gate structure may include a gate dielectric layer, a work-function metal layer and a gate metal pattern for each of a lower nanosheet transistor at a lower stack and an upper nanosheet transistor at an upper stack in the multi-stack semiconductor device.

When there is a requirement to differentiate the gate structure between the lower nanosheet transistor and the upper nanosheet transistor, the work-function metal layer may be differently formed for the two nanosheet transistors. For example, when the multi-stack semiconductor device is to form a complementary-metal-oxide transistor (CMOS) device including opposite polarity field-effect transistors (FETs), that is, a p-type lower nanosheet transistor and an n-type lower nanosheet transistor, a work-function metal layer of a gate structure of the lower nanosheet transistor (i.e., a lower work-function metal layer of a lower gate structure) and a work-function metal layer of a gate structure of the upper nanosheet transistor (i.e., an upper work-function metal layer of an upper gate structure) may be formed to include different materials or material compounds. Thus, the lower gate structure and the upper gate structure may be able to have different threshold voltages to drive the lower nanosheet transistor and the upper nanosheet transistor.

The gate structure having the lower work-function metal layer and the upper work-function metal layer different from each other may be obtained by forming a gate dielectric layer surrounding each of nanosheet channel layers for the lower nanosheet transistor and the upper nanosheet transistor, forming a work-function metal layer surrounding the gate dielectric layer, removing the work-function metal layer formed on the nanosheet channel layers at an upper stack leaving the work-function metal layer only on the nanosheet channel layers at a lower stack (i.e., the lower work-function metal layer), forming another work-function metal layer (i.e., the upper work-function metal layer) to surround the nanosheet channel layers at the upper stack, and forming a gate metal pattern (or gate electrode) to surround the two work-function metal layers.

However, the above process of forming the different work-function metal layers exposes various challenges. For example, during the removal operation of the work-function metal layer initially formed on the upper-stack nanosheet channel layers through wet etching, the work-function metal layer formed on the lower-stack nanosheet channel layers (i.e., the lower work-function metal layer) may also be etched or damaged by the wet etching. This risk may increase when the lower-stack nanosheet channel layers and the upper-stack nanosheet channel layers have different channel widths. Thus, a process of protecting the lower work-function metal layer is necessary for manufacturing the multi-stack semiconductor device, which may require additional complicated patterning and deposition steps.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides multi-stack semiconductor devices including a lower nanosheet transistor and an upper nanosheet transistor in which a gate structure includes a polycrystalline silicon (poly-Si) structure, and methods of manufacturing the same.

According to an embodiment, there is provided a multi-stack semiconductor device which may include: a substrate; a lower field-effect transistor in which a lower channel structure is surrounded by a lower gate structure including a lower work-function metal layer and a lower gate electrode; and an upper field-effect transistor in which an upper channel structure is surrounded by an upper gate structure including an upper work-function metal layer and an upper gate electrode, wherein each of the lower gate electrode and the upper gate electrode includes a metal or a metal compound, and wherein the lower gate electrode includes polycrystalline silicon (poly-Si) or poly-Si including a dopant, and the upper gate electrode includes a metal or a metal compound.

According to an embodiment, the multi-stack semiconductor device may further include a gate inner spacer which is formed between the lower work-function metal layer and the upper work-function metal layer at selected regions where the lower channel structure is not vertically overlapped by the upper channel structure.

According to an embodiment, there is provided a multi-stack semiconductor device which may include: a lower field-effect transistor in which a lower channel structure is surrounded by a lower gate structure including a lower work-function metal layer and a lower gate electrode; an upper field-effect transistor in which an upper channel structure is surrounded by an upper gate structure including an upper work-function metal layer and an upper gate electrode; and a polycrystalline silicon (poly-Si) layer between the lower work-function metal layer and the upper work-function metal layer at selected regions on the lower work-function metal layer, wherein each of the lower gate electrode and the upper gate electrode includes a metal or a metal compound, and herein the poly-Si layer includes poly-Si or poly-Si including a dopant.

According to embodiments, there is provided a method of manufacturing a multi-stack semiconductor device including a lower field-effect transistor and an upper field-effect transistor. The method may include: (a) providing a multi-stack semiconductor device structure including a lower channel structure at a lower stack and an upper channel structure at an upper stack, the lower channel structure and the upper channel structure being surrounded by an initial gate structure which includes an initial work-function metal layer and an initial gate electrode pattern; (b) removing the initial gate electrode pattern from the upper stack, leaving the initial gate electrode remaining at the lower stack as a lower gate electrode for the lower field-effect transistor; (c) removing the initial work-function metal layer from the upper stack, leaving the initial work-function metal layer remaining at the lower stack as a lower work-function metal layer for the lower field-effect transistor; (d) forming an upper work-function metal layer for the upper field-effect transistor on the upper channel structure and the lower gate electrode; and (e) forming an upper gate electrode for the upper field-effect transistor on the upper work-function metal layer, wherein the initial gate electrode pattern includes polycrystalline silicon (poly-Si) or poly-Si including a dopant, and the upper gate electrode includes a metal or a metal compound.

According to embodiments, there is provided a method of manufacturing a multi-stack semiconductor device including a lower field-effect transistor and an upper field-effect transistor. The method may include: (a) providing a multi-stack semiconductor device structure including a lower channel structure at a lower stack and an upper channel structure at an upper stack, the lower channel structure and the upper channel structure being surrounded by an initial gate structure which includes an initial work-function metal layer and an initial gate electrode pattern; (b) removing the initial gate electrode pattern and the initial work-function metal layer from the upper stack, except between upper channel layers of the upper channel structure, such that the initial work-function metal layer is removed further down than the initial gate electrode pattern at selected regions, thereby forming a plurality of grooves at the selected regions on the initial work-function metal layer remaining at the lower stack, and leaving the initial gate electrode at the lower stack as a lower gate electrode for the lower field-effect transistor; (c) forming a gate inner spacer in the grooves, and removing the initial work-function metal layer between the upper channel layers, thereby leaving the initial work-function metal layer at the lower stack as a lower work-function metal layer for the lower field-effect transistor; (d) forming an upper work-function metal layer for the upper field-effect transistor on the upper channel structure, the lower gate electrode, and the gate inner spacer; and (e) forming an upper gate electrode for the upper field-effect transistor on the upper work-function metal layer, wherein the initial gate electrode pattern includes polycrystalline silicon (poly-Si) or poly-Si including a dopant, and the upper gate electrode includes a metal or a metal compound.

According to embodiments, there is provided a method of manufacturing a multi-stack semiconductor device including a lower nanosheet transistor and an upper nanosheet transistor. The method may include: (a) providing a multi-stack semiconductor device structure including a lower channel structure at a lower stack and an upper channel structure at an upper stack, the lower channel structure and the upper channel structure being surrounded by an initial gate structure which includes an initial work-function metal layer and an initial gate electrode pattern; (b) removing the initial gate electrode pattern and the initial work-function metal layer from the upper stack, except between upper channel layers of the upper channel structure and below a lowermost one of the upper channel layers,; (c) forming a polycrystalline silicon (poly-Si) structure, including poly-Si or poly-Si including a dopant, in a space where the initial work-function metal layer and the initial gate electrode pattern are removed in operation (b, thereby leaving the initial gate electrode at the lower stack below the poly-Si structure as a lower gate electrode for the lower field-effect transistor; (d) removing the poly-Si structure down to a level between the lower channel structure and the upper channel structure to form a poly-Si layer therebetween; (e) removing the initial work-function metal layer between the upper channel layers and below the lowermost one of the upper channel layers based on the poly-Si layer, thereby leaving the initial work-function metal layer below the poly-Si layer as a lower work-function metal layer for the lower field-effect transistor; (f) forming an upper work-function metal layer, including a material different from the initial work-function metal layer, for the upper field-effect transistor on the upper channel structure and the poly-Si layer; and (g) forming an upper gate electrode for the upper field-effect transistor on the upper work-function metal layer, wherein each of the initial gate electrode pattern and the upper gate electrode includes a metal or a metal compound.

### BRIEF DESCRIPTION OF DRAWINGS

Example embodiments of the inventive concept will be more clearly understood from the following detailed description taken in conjunction with the accompanying drawings in which:
FIGS. 1A-1E illustrate a multi-stack semiconductor device in which a lower gate electrode for a lower nanosheet transistor is formed of polycrystalline silicon (poly-Si) while an upper gate electrode for an upper nanosheet transistor is formed of a metal or a metal compound, according to an embodiment;
FIG. 2 is a flowchart of a method of manufacturing a multi-stack semiconductor device in which a lower gate electrode for a lower nanosheet transistor is formed of poly-Si while an upper gate electrode for an upper nanosheet transistor is formed of a metal or a metal compound, according to an embodiment.
FIGS. 3-7 illustrate multi-stack semiconductor device structures in channel-width direction views after respective steps of a method of manufacturing the multi-stack semiconductor device referred to in the flowchart of FIG. 2, according to an embodiment;
FIGS. 8A-8D illustrate a multi-stack semiconductor device in which a lower gate electrode for a lower nanosheet transistor is formed of poly-Si or poly-Si including a dopant, and includes a gate inner spacer protecting a lower work-function metal layer for a lower gate structure, according to an embodiment;
FIG. 9 is a flowchart of a method of manufacturing a multi-stack semiconductor device in which a lower gate electrode for a lower nanosheet transistor is formed of poly-Si and includes a gate inner spacer protecting a lower work-function metal layer for a lower gate structure, according to an embodiment;
FIGS. 10-14 illustrate multi-stack semiconductor device structures in channel-width direction views after respective steps of a method of manufacturing the multi-stack semiconductor device referred to in the flowchart of FIG. 9, according to an embodiment;
FIGS. 15A-15D illustrate a multi-stack semiconductor device in which a poly-Si layer is formed between a lower gate structure and an upper gate structure , according to an embodiment;
FIG. 16 is a flowchart of a method of manufacturing a multi-stack semiconductor device in which a poly-Si layer is formed between a lower gate structure and an upper gate structure, and a lower gate electrode and an upper gate electrode are both formed of a metal or a metal compound, according to an embodiment;
FIGS. 17-22 illustrate multi-stack semiconductor device structures in channel-width direction views after respective steps of a method of manufacturing the multi-stack semiconductor device referred to in the flowchart of FIG. 16, according to an embodiment; and
FIG. 23 is a schematic block diagram illustrating an electronic device including a multi-stack semiconductor device which may include a gate structure formed of a poly-Si or poly-Si including a dopant, according to an example embodiment.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, sacrificial isolation layers and channel isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be understood that, although the terms 1^{st}, 2^{nd}, 3^{rd}, 4^{th}, etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor may or may not be described in detail herein. For example, a certain isolation layer or structure of a semiconductor device may be omitted herein when this layer or structure is not related to the various of aspects of the embodiments.

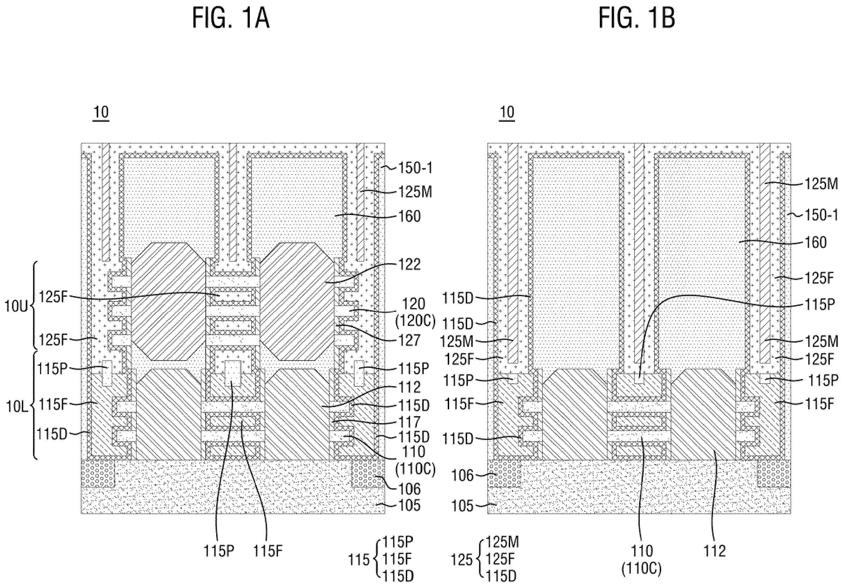

FIGS. 1A-1E illustrate a multi-stack semiconductor device in which a lower gate electrode for a lower nanosheet transistor is formed of polycrystalline silicon (poly-Si) while an upper gate electrode for an upper nanosheet transistor is formed of a metal or a metal compound, according to an embodiment.

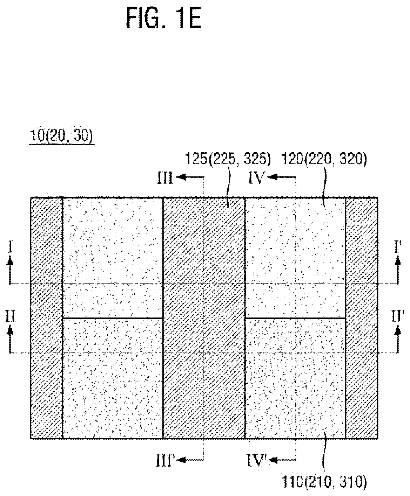

FIG. 1E is a top plan view of each of multi-stack semiconductor devices 10, 20 and 30 shown in FIGS. 1A-1D, 8A-8D and 15A-15D, respectively. FIG. 1E is provided herein only to show how a channel structure and a gate structure surrounding the channel structure are relatively arranged in each of the multi-stack semiconductor devices 10, 20 and 30. Thus, FIG. 1E does not show the other structures or elements illustrated in FIGS. 1A-1D, 8A-8D and 15A-15D, for brevity purposes. FIGS. 1A-1D, 8A-8D and 15A-15D are cross-sectional views of the multi-stack semiconductor devices 10, 20 and 30 taken along lines I-I', II-II', III-III' and IV-IV' indicated in FIG. 1E, respectively.

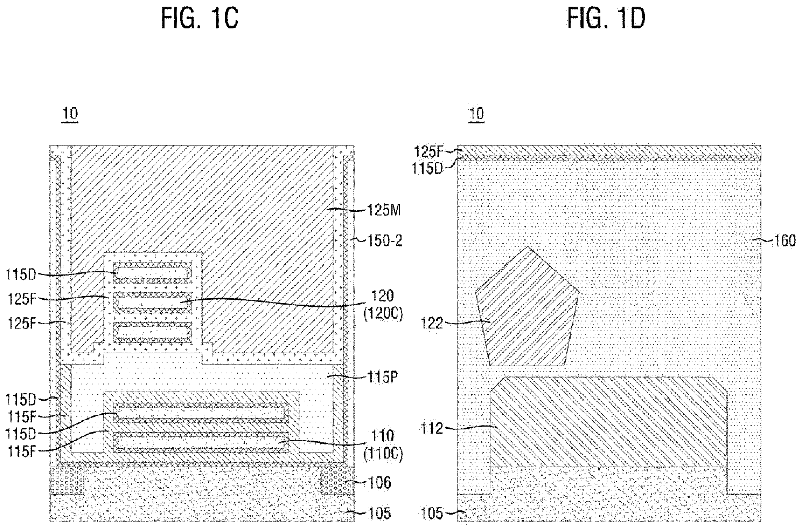

It is understood herein that the lines I-I' and II-II' indicate a channel-length direction, and the lines III-III' and IV-IV' indicate a channel-width direction of the multi-stack semiconductor devices 10, 20 and 30. Thus, FIGS. 1A-1B, 8A-8B and 15A-15B show lengths of channel structures and source/drain regions connected by the channel structures, and FIGS. 1C-1D, 8C-8D and 15C-15D show widths of the channel structures and the source/drain regions, in the multi-stack semiconductor devices 10, 20 and 30, respectively.

Referring to FIGS. 1A-1C, the multi-stack semiconductor device 10 may include a lower nanosheet transistor 10L at a lower stack and an upper nanosheet transistor 10U at an upper stack, on a substrate 105. The substrate 105 may be a bulk substrate of a semiconductor material, for example, silicon, or a silicon-on-insulator (SOI) substrate. A shallow trench isolation (STI) structure 106 including silicon nitride or silicon oxide may be formed on or around the substrate 105 to isolate the multi-stack semiconductor device 10 from another multi-stack semiconductor device or circuit element in an integrated circuit including the multi-stack semiconductor device 10.

The lower nanosheet transistor 10L may include a plurality of lower channel layers 110C as a lower channel structure 110 of the multi-stack semiconductor device 10. The lower channel layers 110C may be nanosheet layers which are vertically stacked and horizontally extended above the substrate 105, and surrounded by a lower gate structure 115. The upper nanosheet transistor 10U may also include a plurality of upper channel layers 120C as an upper channel structure 120 of the multi-stack semiconductor device 10. Like the lower channel layers 110C, the upper channel layers 120C may also be nanosheet layers which are vertically stacked and horizontally extended above the lower channel layers 110C, and surrounded by an upper gate structure 125. Each of the lower channel layers 110C and the upper channel layers 120C may include a semiconductor material(s) such as silicon that may be epitaxially grown from the substrate 105.

According to an embodiment, each of the lower channel layers 110C and the upper channel layers 120C may have an equal thickness in a range of about 4-6 nm, and an equal length in a range of about 18-24 nm not being limited thereto. However, each of the upper channel layers 120C may have a smaller width than each of the lower channel layers 110C, according to an embodiment, as shown in FIG. 1C. For example, the upper channel layers 120C may each have a width of about 23-27 nm and the lower channel layers 110C may each have a width of about 43-47 nm. Due to this channel-width difference between the lower channel structure 110 and the upper channel structure 120, lower source/drain regions formed on the lower channel structure 110 may also have a different width from upper source/drain regions formed on the upper channel structure 120, as shown in FIG. 1D, which will be further described later.

In contrast, the upper channel structure 120 may have a greater number of channel layers than the lower channel structure 110, according to an embodiment. For example, the number of the upper channel layers 120C may be three (3) while the number of the lower channel layers 110C may be two (2), although these numbers are not limited thereto. Thus, while the channel width is differentiated between the lower channel structure 110 and the upper channel structure 120, these two channel structures 110 and 120 may be formed of different numbers of channel layers so that the multi-stack semiconductor device 10 may have an equal or similar effective channel width (W_{eff}) in the lower nanosheet transistor 10L and the upper nanosheet transistor 10U. However, according to embodiments, the two nanosheet transistors 10L and 10U may not have an equal of similar effective channel width.

Referring to FIGS. 1A-1C, lower source/drain regions 112 may be formed on both ends of the lower channel structure 110 including the lower channel layers 110C in the channel-length direction. The lower source/drain regions 112 may also be epitaxial structures grown from the lower channel layers 110C and/or the substrate 105, and thus, may include the same or similar material(s) of the lower channel layers 110C and the substrate 105. Each of the lower channel layers 110C, at both ends thereof, may be connected to the lower source/drain regions 112. Similarly, upper source/drain regions 122 may be formed on both ends of the upper channel structure including the upper channel layers 120C in the channel-length direction. The upper source/drain regions 122 may be epitaxial structures grown from the upper channel layers 120C, and thus, may include the same or similar material(s) of the lower channel layers 110C. Each of the upper channel layers 120C, at both ends thereof, may be connected to the upper source/drain regions 122.

The lower source/drain regions 112 and the upper source/drain regions 122 may be doped or implanted with p-type or n-type dopants, depending on the type of field-effect transistor (FET) to be formed by the lower or upper source/drain regions 112 and 122. For example, the lower source/drain regions 112 may be doped or implanted with p-type dopants such as boron (B), gallium (Ga), etc. to form the lower nanosheet transistor 10L as a p-type FET (PFET), and the upper source/drain regions 122 may be doped with or implanted by n-type dopants such as phosphorous (As), arsenic (Sb), indium (In), etc. to form the upper nanosheet transistor 10U as an n-type FET (NFET). However, the embodiments are not limited thereto. The lower source/drain regions 112 may include the n-type dopants while the upper source/drain regions 122 include the p-type dopants. Further, the lower source/drain regions 112 and the upper source/drain regions 122 may all include the n-type dopants or the p-type dopants.

As shown in FIG. 1A, an interlayer dielectric (ILD) structure 160 may be formed above the upper source/drain regions 122 and between the upper source/drain regions 122 and the lower source/drain regions 112 at a region where the lower channel structure 110 and the lower source/drain regions 112 are vertically overlapped by the upper channel structure 120 and the upper source/drain regions 122, respectively (hereafter "overlapping region"). As shown in FIG. 1B, the overlapping region includes the cross-section of the multi-stack semiconductor device (FIG. 1A) along the lines I-I' shown in FIG. 1E. The ILD structure 160 may also be formed above the lower source/drain regions 112 at a region where the lower channel structure 110 and the lower source/drain regions 112 are not vertically overlapped by the upper channel structure 120 and the upper source/drain regions 122, respectively (hereafter "non-overlapping region"). The non-overlapping region includes the cross-section of the multi-stack semiconductor device (FIG. 1B) along the lines II-II' shown in FIG. 1E. The multi-stack semiconductor device 10 may have the overlapping region and the non-overlapping region due to the difference of the channel width between the lower channel structure 110 and the upper channel structure 120 as described above. The ILD structure 160 may isolate the lower source/drain regions 112 from the upper source/drain regions 122, and may also isolate the lower source/drain regions 112 and the upper source/drain regions 122 from other circuit elements in the multi-stack semiconductor device 10.

FIGS. 1A-1C also show that a 1^{st} isolation structure 150-1 and a 2^{nd} isolation structure 150-2 may be formed at sides of the multi-stack semiconductor device 10. According to an embodiment, the 1^{st} isolation structure 150-1 may be a diffusion break structure that isolates the lower source/drain regions 112 and the upper source/drain regions 122 from other source/drain regions in an integrated circuit including the multi-stack semiconductor device 10. According to an embodiment, the 2^{nd} isolation structure 150-2 may be a gate-cut isolation structure that isolates the lower gate structure 115 and the upper gate structure from other gate structures in the channel width-direction. The 1^{st} isolation structure 150-1 and the 2^{nd} isolation structure 150-2 may each include silicon oxide or silicon nitride, not being limited thereto.

FIG. 1D shows that the upper source/drain region 122 may have a smaller width than the lower source/drain region 112 in the channel-width direction as described earlier. This is because the upper source/drain region 122 is grown from the upper channel structure 120 including the upper channel layers 120C having a smaller width than the lower channel structure 110 including the lower channel layers 110C, as described above and shown in FIG. 1C. Due to this channel-width difference, a portion of the lower channel structure 110 may not be vertically overlapped by the upper channel structure 120 as shown in FIG. 1C, and thus, the overlapping region is distinguished from the non-overlapping region in the multi-stack semiconductor device 10.

The multi-stack semiconductor device 10 may have the above-described channel-width difference to enable a lower source/drain region contact structure (not shown), which is extended down from a back-end-of-line (BEOL) structure (not shown) above the multi-stack semiconductor device, to land on a top surface of the lower source/drain region 112 shown in FIG. 1D. Otherwise, if the lower channel structure 110 and the upper channel structure 120 have an equal channel width, the lower source/drain regions 112 and the upper source/drain regions 122 may have an equal width, and then, the lower source/drain region contact structure may have to be bent and connected to a side surface of the lower source/drain region 112, the formation of which is difficult and error prone.

While the lower source/drain regions 112 are connected to the lower channel structure 110, they may be isolated from the lower gate structure 115 by a lower inner spacer 117, as shown in FIG. 1A. Similarly, the upper source/drain regions 122 connected to the upper channel structure 120 may be isolated from the upper gate structure 125 by an upper inner spacer 127, as also shown in FIG. 1A. The inner spacers 117 and 127 may be formed of one or more materials including silicon nitride, silicon oxide, silicon oxynitride, silicon oxycarbide, silicon boron carbonitride, silicon oxy carbonitride, etc. not being limited thereto.

Referring to FIGS. 1A-1C, the lower gate structure 115 may include a lower portion of a gate dielectric layer 115D, a lower work-function metal layer 115F formed on the lower portion of the gate dielectric layer 115D, and a lower gate electrode 115P formed on the lower work-function metal layer 115F. Further, the upper gate structure 125 may include an upper portion of the gate dielectric layer 115D, an upper work-function metal layer 125F formed on the upper portion of the gate dielectric layer 115D, and an upper gate electrode 125M formed on the upper work-function metal layer 125F. The lower portion and the upper portion of the gate dielectric layer 115D may be continuously-connected structure formed at the same time in manufacturing the multi-stack semiconductor device 10.

In addition to surrounding the channel layers 110C and 120C, the gate dielectric layer 115D may also be formed on a top surface of the substrate 105, and may be extended on a top surface of the STI structure 106 out to the 1^{st} isolation structure 150-1 in the channel-length direction and the 2^{nd} isolation structure 150-2 in the channel-width direction. Further, the gate dielectric layer 115D may be extended upward along sidewalls of the 1^{st} isolation structure 150-1 and the 2^{nd} isolation structure 150-2, and may also be formed on top surfaces of these isolation structures 150-1 and 150-2. In addition, the gate dielectric layer 115D surrounding the lower channel layers 110C and the upper channel layers 120C may be extended along sidewalls of the ILD structure 160, and may be formed on a top surface of the ILD structure 160.

The gate dielectric layer 115D may each include an interfacial layer and a high-k layer. The interfacial layer may be provided to protect the channel layers 110C and 120C, facilitate growth of the high-k layer thereon, and provide a necessary characteristic interface with the channel layers 110C and 120C. The interfacial layer may be formed of silicon oxide, silicon oxynitride, not being limited thereto. The high-k layer may be provided to allow an increased gate capacitance without associated current leakage at the channel layers 110C and 120C. The high-κ layer may be formed of one or more materials of hafnium oxide, hafnium silicate, hafnium oxynitride, hafnium silicon oxynitride, hafnium aluminum oxide, lanthanum oxide, lanthanum aluminum oxide, zirconium oxide, zirconium silicate, zirconium oxynitride, zirconium silicon oxynitride, titanium oxide, barium strontium titanium oxide, barium titanium oxide, strontium titanium oxide, yttrium oxide, aluminum oxide, tantalum oxide and/or lead scandium tantalum oxide, not being limited thereto.

The gate dielectric layer 115D may be surrounded by the lower work-function metal layer 115F and the upper work-function metal layer 125F that may define polarity types of the lower nanosheet transistor 10L and the upper nanosheet transistor 10U between p-type and n-type and/or control respective gate threshold voltages for the two nanosheet transistors 10L and 10U. According to an embodiment, the lower work-function metal layer 115F may also be formed on the gate dielectric layer 115D on the substrate 105, the STI structure 106, lower portions of the 1^{st} isolation structure 150-1 and the 2^{nd} isolation structure 150-2, as shown in FIGS. 1A-1C. According to an embodiment, the upper work-function metal layer 125F formed below a lowermost one of the upper channel layers 120C may be laterally extended on the lower gate electrode 115P out to the 1^{st} isolation structure 150-1 and the 2^{nd} isolation structure 150-2 to be connected to the lower work-function metal layer 115F. Further, this upper work-function metal layer 125F may also be formed on the sidewalls and the top surfaces of the 1^{st} isolation structure 150-1, the 2^{nd} isolation structure 150-2 and the ILD structure 160 with the gate dielectric layer 115D therebetween.

The lower work-function metal layer 115F and the upper work-function metal layer 125F controlling respective threshold voltages for the lower gate structure 115 and the upper gate structure 125 may each be formed of titanium (Ti), tantalum (Ta) or their compound such as TiN, TiAl, TiAlN, TaN, TiC, TaC, TiAlC, TaCN, TaSiN, not being limited thereto. However, when the lower nanosheet transistor 10L and the upper nanosheet transistor 10U are to form a PFET and an NFET, respectively, the lower work-function metal layer 115F and the upper work-function metal layer 125F may be formed of different materials or material compounds to control the lower gate structure 115 and the upper gate structure 125. According to an embodiment, to form an NFET, a combination of TiN and TiC may be included in the upper work-function metal layer 125F, while TiN without TiC or without carbon may be included in the lower work-function metal layer 115F to form a PFET. However, the embodiments are not limited thereto. The lower work-function metal layer 115F may be for the NFET, while the upper work-function metal layer 125F may be for the PFET, or both of the work-function metal layers 115F and 125F may be one of the NFET and the PFET.

According to an embodiment, the lower gate electrode 115P may be formed of a material(s) including poly-Si, while the upper gate electrode 125M may be formed of tungsten (W), ruthenium (Ru), molybdenum (Mo), cobalt (Co), aluminum (Al), copper (Cu) or their compound, not being limited thereto. Each of the lower gate electrode 115P and the upper gate electrode 125M may be configured to receive an input voltage for the multi-stack semiconductor device 10 or for an internal routing of the multi-stack semiconductor device 10 to an adjacent circuit in an integrated circuit including the multi-stack semiconductor device 10. According to an embodiment, the poly-Si to form the lower gate electrode 115P may be doped or implanted with one or more dopants such as boron (B), gallium (Ga), phosphorous (As), arsenic (Sb), indium (In), etc. to enhance conductor attributes. Depending on the type of FET to be formed by the lower nanosheet transistor 10L, the lower gate electrode 115P may include one or more selected dopants.

According to an embodiment, the lower gate electrode 115P and the upper gate electrode 125M may be connected to each other through the upper work-function metal layer 125F therebetween as shown in FIG. 1C to form, for example, a CMOS device.

According to an embodiment, the lower gate electrode 115P and the upper gate electrode 125M may not be formed between the lower channel layers 110C and between the upper channel layers 120C while the lower work-function metal layer 115F and the upper work-function metal layer 125F may be formed therein, respectively. This is because nanoscale channel intervals between the channel layers 110C and/or 120C may not be wide enough to accommodate the gate electrodes 115P and/or 125M therein. However, since the work-function metal layers 115F and 125F are connected to the gate electrodes 115P and 125M, respectively, the gate electrodes 115P and 125P may not need to be formed therein.

Although poly-Si may incur a higher gate resistance than the metal or metal compound for a gate electrode, poly-Si may be used as a conducting gate electrode due to its crystalline metallurgical structure. Further, when poly-Si doped or implanted with the above-described dopants forms a gate electrode, it may be a cost-effective alternative to metal or metal compounds for a gate electrode. Also, the lower gate electrode 115P including poly-Si provides a clearer visible boundary between the lower gate electrode 115P and the upper gate electrode 125M.

Moreover, the lower gate electrode 115P may be formed of poly-Si because wet etch selectivity of poly-Si against the metal or metal compound forming the lower work-function metal layer 115F may be able to prevent the lower work-function metal layer 115F from being etched or damaged in a step of forming the upper work-function metal layer 125F in the multi-stack semiconductor device 10, as will be described below.

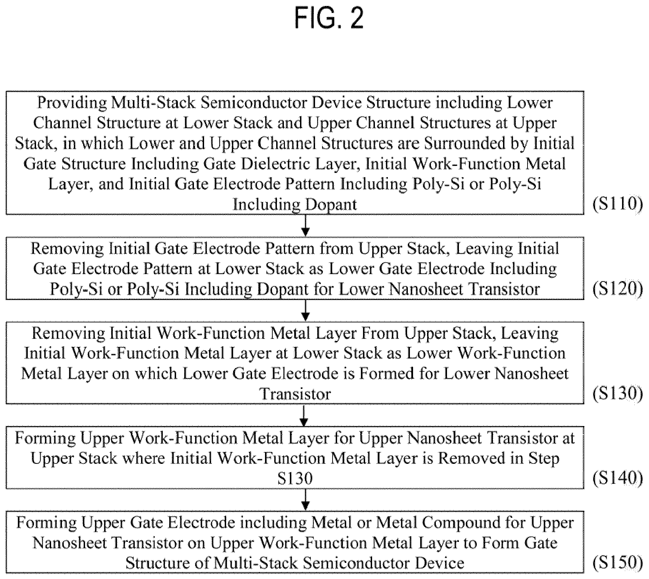

Herebelow, a method of manufacturing a multi-stack semiconductor device corresponding to the multi-stack semiconductor device 10 shown in FIGS. 1A-1D is described in reference to FIGS. 2-7.

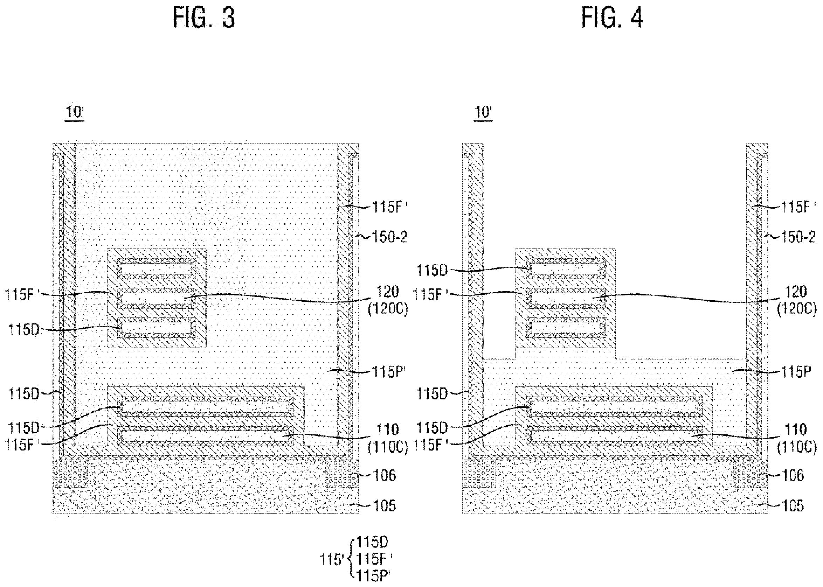

FIG. 2 is a flowchart of a method of manufacturing a multi-stack semiconductor device in which a lower gate electrode for a lower nanosheet transistor is formed of poly-Si while an upper gate electrode for an upper nanosheet transistor is formed of a metal or a metal compound, according to an embodiment. FIGS. 3-7 illustrate multi-stack semiconductor device structures in channel-width direction views after respective steps of a method of manufacturing the multi-stack semiconductor device referred to in the flowchart of FIG. 2, according to an embodiment. It is understood that the method of manufacturing the multi-stack semiconductor device is described in reference to channel-width direction views for brevity purposes.

The multi-stack semiconductor device structures shown in FIGS. 3-7 may be the same as or correspond to the multi-stack semiconductor device 10 shown in FIGS. 1A-1D. Thus, duplicate descriptions the same or corresponding structures or elements may be omitted herebelow. The same reference numbers and reference characters used for describing the multi-stack semiconductor device 10 in FIGS. 1A-1D may be used herebelow when the same structures or elements are referred to.

In step S110 of FIG. 2, a multi-stack semiconductor device structure including a lower channel structure at a lower stack and an upper channel structures at an upper stack may be provided, in which the lower channel structure and the upper channel structure are surrounded by an initial gate structure including a gate dielectric layer, an initial work-function metal layer, and an initial gate electrode pattern including poly-Si or poly-Si including a dopant.

Referring to FIG. 3, a multi-stack semiconductor device structure 10' including the lower channel structure 110 at a lower stack and the upper channel structure 120 at an upper stack may be provided on the substrate 105. The two channel structures 110 and 120 may be surrounded by an initial gate structure 115'. Each of lower channel structure 110 and the upper channel structure 120 may be formed of a plurality of nanosheet layers as channel layers, according to an embodiment. The nanosheet layers of the channel structures 110 and 120 may have been epitaxially grown from the substrate 105. Although not shown in FIG. 2, the lower source/drain regions 112 and the upper source/drain regions 122 may be formed on both ends of the lower channel structure 110 and both ends of the upper channel structure 120, respectively (as shown in FIGS. 1A-1D).

In the multi-stack semiconductor device structure 10', the upper channel structure 120 at the upper stack may have a smaller channel width than the lower channel structure 110 at the lower stack. Accordingly, the upper source/drain regions 122 grown from the upper channel structure 120 may have a smaller width than the lower source/drain regions 112 grown from the lower channel structure 110 (as shown in FIGS. 1A-1D). This channel-width difference and the source/drain region-width difference may be provided to facilitate connection of a source/drain contact structure on a top surface of the lower source/drain regions 112, as described above in reference to FIGS. 1A-1D.

The initial gate structure 115' of the multi-stack semiconductor device structure 10' may include the gate dielectric layer 115D, an initial work-function metal layer 115F' and an initial gate electrode pattern 115P'. The gate dielectric layer 115D' with the initial work-function metal layer 115F' thereon may surround both the lower channel layers 110C of the lower channel structure 110 and the upper channel layers 120C of the upper channel structure 120. The initial gate electrode pattern 115P' may be patterned to be formed on the initial work-function metal layer 115F'. Here, the initial gate electrode pattern 115P', which is to form the lower gate electrode 115P of the multi-stack semiconductor device 10 shown in FIGS. 1A-1D in a later step, may be formed of poly-Si or poly-Si including a dopant, according to an embodiment.

The gate dielectric layer 115D' and the initial work-function metal layer 115F' thereon may be also laterally extended on the substrate 105 and the STI structure 106 to the 1^{st} isolation structure 150-1 (as shown in FIGS. 1A-1B) and the 2^{nd} isolation structure 150-2. The laterally extended gate dielectric layer 115D' and initial work-function metal layer 115F' thereon may also be extended upward along the sidewalls of the two isolation structures 150-1 and 150-2 and may also be formed on the top surfaces thereof. The gate dielectric layer 115D' and the initial work-function metal layer 115F' thereon may also be formed on the sidewalls and the top surface of the ILD structure 160 (as shown in FIGS. 1A-1D).

In step S120 of FIG. 2, the initial gate electrode pattern may be removed from the upper stack, leaving the initial gate electrode pattern at the lower stack as a lower gate electrode including poly-Si or poly-Si including the dopant for a lower nanosheet transistor .

Referring to FIG. 4, the initial gate electrode pattern 115P' may be removed from the upper stack of the multi-stack semiconductor device structure 10', according to an embodiment.

The removal operation in this step may be performed through, for example, photolithography and dry etching such as reactive ion etching (RIE) to selectively remove the initial gate electrode pattern 115P', which is formed of poly-Si or poly-Si including a dopant, down to a level between the two channel structures 110 and 120 without affecting other semiconductor elements including the gate dielectric layer 115D' and the initial work-function metal layer 115F'. For example, hydrogen bromide (HBr) gas plasma mixed with oxygen may be used for an RIE etchant, not being limited thereto. Although not shown, the upper channel structure 120 with a mask pattern thereon may be used as a mask structure for the photolithography and dry etching operation. Thus, after the removal operation in this step, the gate dielectric layer 115D' and the initial work-function metal layer 115F' may still remain at the upper stack of the multi-stack semiconductor device structure 10'.

The initial gate electrode pattern 115P' remaining below the level between the two channel structures 110 and 120 after the removal operation in this step becomes the lower gate electrode 115P for the multi-stack semiconductor device 10.

In step S130 of FIG. 2, the initial work-function metal layer may be removed from the upper stack, leaving the initial work-function metal layer at the lower stack as a lower work-function metal layer on which the lower gate electrode is formed for the lower nanosheet transistor.

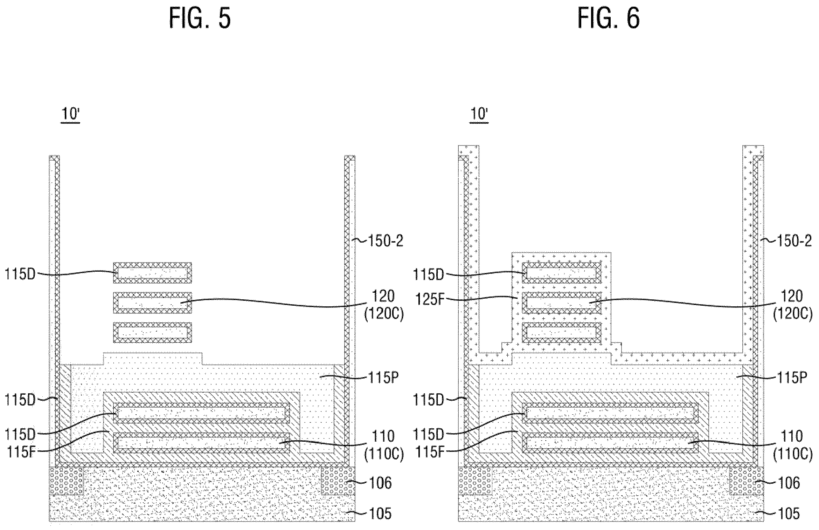

Referring to FIG. 5, the initial work-function metal layer 115F' in the upper stack of the multi-stack semiconductor device structure 10' may be removed leaving the gate dielectric layer 115D, according to an embodiment.

In this step, the initial work-function metal layer 115F' surrounding the upper channel layers 125C and formed between the lowermost one of the upper channel layers 125C and the lower gate electrode 115P may be removed through, for example, wet etching using a wet etchant including hydrogen peroxide, not being limited thereto that may selectively attack the material(s), such as TiN or TiC, forming the initial work-function metal layer 115F' against poly-Si or poly-Si including a dopant forming the lower gate electrode 115P. The wet etching operation may also remove the initial work-function metal layer 115F' formed on the sidewalls and the top surfaces of the 1^{st} isolation structure 150-1 (not shown in FIG. 4), the 2^{nd} isolation structure 150-2 and the ILD structure 160 above the level of a top surface of the initial gate electrode pattern 115P'. However, the gate dielectric layer 115D may survive this wet etching of the initial work-function metal layer 115F'.

Here, since the lower gate electrode 115P is formed of poly-Si or poly-Si including a dopant, wet-etch control to remove the initial work-function metal layer 115F' only to the level of between the two channel structures 110 and 120 may be better performed than a case of using a metal or a metal compound for the lower gate electrode 115P.

By this removal operation, the initial work-function metal layer 115F' above the level of the top surface of the initial gate electrode pattern 115P'may be removed, but the initial work-function metal layer 115F' remaining below the same level becomes the lower work-function metal layer 115F on which the lower gate electrode 115 is formed for the multi-stack semiconductor device 10.

In step S140 of FIG. 2, an upper work-function metal layer for an upper nanosheet transistor may be formed at the upper stack where the initial work-function metal layer is removed in step S130.

Referring to FIG. 6, an upper work-function metal layer 125F may be formed on a place where the initial work-function metal layer 115F' is removed at the upper stack in the previous step, according to an embodiment. Here, the upper work-function metal layer 125F may be formed of a material(s) different from a material(s) forming the initial work-function metal layer 115F', according to an embodiment.

In this step, the upper work-function metal layer 125F replacing the initial work-function metal layer 115F' removed in the previous step may be formed through, for example, atomic layer deposition (ALD), not being limited thereto. The upper work-function metal layer 125F may be conformally formed to surround the upper channel layers 120C. The upper work-function metal layer 125F may also be formed between the lowermost one of the upper channel layer 120C and the top surface of the lower gate electrode 115P. The upper work-function metal layer 125F may be extended out to the 1^{st} isolation structure 150-1 (shown in FIGS. 1A-1B) and the 2^{nd} isolation structure 150-2 on the top surface of the lower gate electrode 115P and a top surface of the lower work-function metal layer on the isolation structures 150-1, 150-2 and the ILD structure 160 (shown in FIGS. 1A-1C) with the gate dielectric layer 115D therebetween. Further, the upper work-function metal layer 125F may be formed on the sidewalls and the top surfaces of the isolation structure 150-1, 150-2 and the ILD structure 160 (shown in FIGS. 1A-1C) with the gate dielectric layer 115D therebetween.

In step S150 of FIG. 2, an upper gate electrode including a metal or a metal compound for the upper nanosheet transistor may be formed on the upper work-function metal layer to form a gate structure of a multi-stack semiconductor device in which at least the lower gate electrode and the upper gate electrode include different materials.

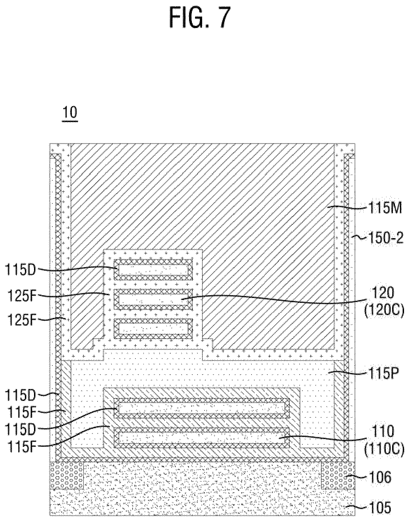

Referring to FIG. 7, the upper gate electrode 125M may be formed on the upper work-function metal layer 125F and planarized to complete a gate structure of the multi-stack semiconductor device 10 shown in FIGS. 1A-1D, according to an embodiment.

The upper gate electrode 125M may be deposited through, for example, physical vapor deposition (PVD), chemical vapor deposition (CVD), plasma enhanced chemical vapor deposition (PECVD), or combinations thereof, not being limited thereto. The planarization of the upper gate electrode 125M may be performed through, for example, a chemical mechanical planarization (CMP) technique, not being limited thereto, so that a top surface of the upper gate electrode 125M may be coplanar with the upper work-function metal layer 125F formed on the top surfaces of the isolation structures 150-1, 150-2 and the ILD structure 160.

Through the above steps, the multi-stack semiconductor device 10 including the lower gate electrode 115P formed of cost-effective poly-Si or poly-Si including a dopant may be obtained. Further, the poly-Si or poly-Si including a dopant may also be able to protect the lower work-function metal layer 115F from being damaged or etched based on etch selectivity of poly-Si against a metal or a metal compound in the step of forming the upper work-function metal layer 125F.

However, the above embodiment may still expose a risk of the lower work-function metal layer 115F being etched or damaged in the process of manufacturing the multi-stack semiconductor device 10. For example, when the initial work-function metal layer 115F' in the upper stack of the multi-stack semiconductor device structure 10' is wetetched as shown in FIG. 4, the initial work-function metal layer 115F' at a side of the lower gate electrode 115P may also be etched or damaged. Thus, in the following embodiment, an additional isolation structure is introduced to better protect a lower work-function metal layer of a multi-stack semiconductor device.

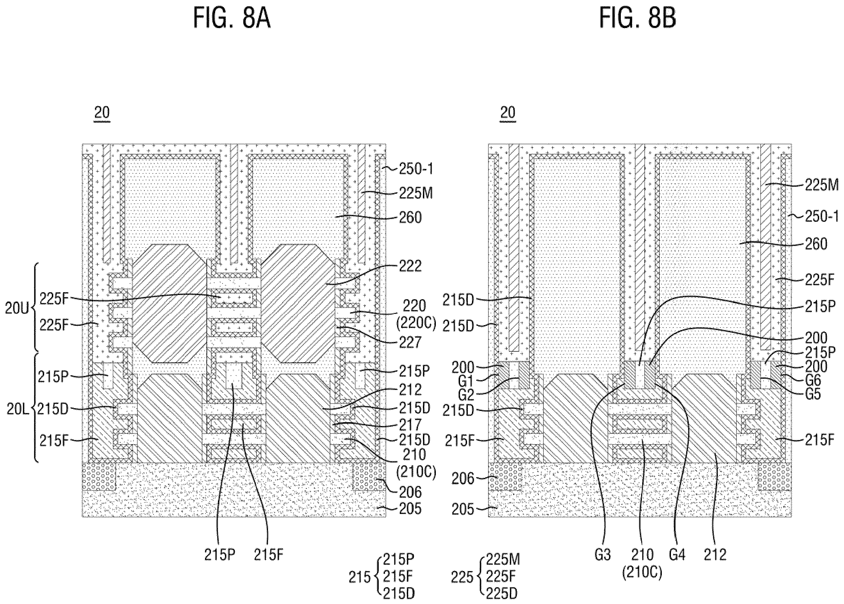

FIGS. 8A-8D illustrate a multi-stack semiconductor device in which a lower gate electrode for a lower nanosheet transistor is formed of poly-Si or poly-Si including a dopant, and includes a gate inner spacer protecting a lower work-function metal layer for a lower gate structure, according to an embodiment.

Referring to FIGS. 8A-8D, a multi-stack semiconductor device 20 may include a lower nanosheet transistor 20L and an upper nanosheet transistor 20U formed on the substrate 205, and an STI structure 206 may also be formed on or around the substrate 205.

Various structures and elements forming the multi-stack semiconductor device 20 may be the same or similar to those of the multi-stack semiconductor device 10 shown in FIGS. 1A-1D in terms of their structural, functional and material characteristics. For example, the lower nanosheet transistor 20L may include a lower channel structure 210 including lower channel layers 210C, a lower gate structure 215 including a gate dielectric layer 215D and a lower gate electrode 215P, and lower source/drain regions 212, which may be the same as or similar to the corresponding structures or elements of the lower nanosheet transistor 10L of the multi-stack semiconductor device 10. Further, the upper nanosheet transistor 20U may include an upper channel structure 220 including upper channel layers 220C, an upper gate structure 225 including the gate dielectric layer 215D, an upper work-function metal layer 225F and an upper gate electrode 225M, and upper source/drain regions 222, which may be the same as or similar to the corresponding structures or elements of the upper nanosheet transistor 10U of the multi-stack semiconductor device 10. A lower inner spacer 217, an upper inner spacer 227, a 1^{st} isolation structure 250-1, a 2^{nd} isolation structure 250-2 and an ILD structure 260 in the multi-stack semiconductor device 20 may also be the same as or similar to the corresponding structures or elements in the multi-stack semiconductor device 10. In addition, the upper channel structure 220 may have a shorter channel width than the lower channel structure 210 as in the multi-stack semiconductor device 10. Thus, duplicate descriptions thereof are omitted, and only different aspects of the multi-stack semiconductor device 20 are described herebelow.

FIG. 8B shows that, at the non-overlapping region, the lower work-function metal layer 215F may not be connected to the upper work-function metal layer 225F while the lower work-function metal layer 115F may be connected to the upper work-function metal layer 115F as shown in FIG. 1B. This is because, as will be described later, 1^{st} to 6^{th} grooves G1-G6, which may include a gate inner spacer 200 therein, may be formed on the lower work-function metal layer 215F below a level of a top surface of the lower gate electrode 215P at this non-overlapping region, according to an embodiment. A top surface of the gate inner spacer 200 in the 1^{st} to 6^{th} grooves G1-G6 may be coplanar with the top surface of the lower gate electrode 215P, according to an embodiment. The 1^{st} to 6^{th} grooves G1-G6 with the gate inner spacer 200 therein may be extended along the 1^{st} isolation structure 250-1 in the channel-width direction, according to an embodiment.

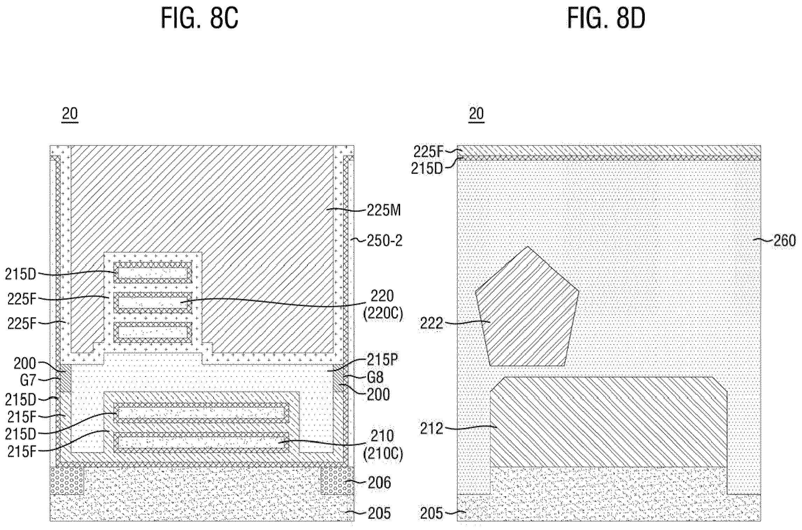

FIG. 8C also shows that the lower work-function metal layer 215F may not be connected to the upper work-function metal layer 225F. This is because 7^{th} and 8^{th} grooves G7-G8, which may also include the gate inner spacer 200 therein, may be formed on the lower work-function metal layer 215F below the level of the top surface of the lower gate electrode 215P at this non-overlapping region, according to an embodiment. Like the gate inner spacer 200 in the 1^{st} to 6^{th} grooves G1-G6, the gate inner spacer 200 in the 7^{th} and 8^{th} grooves G7-G8 may have a top surface which may be coplanar with the top surface of the lower gate electrode 215P, according to an embodiment.

The 7^{th} and 8^{th} grooves G7-G8 may be respectively formed at two side surfaces of the lower gate electrode 215P opposite to each other in the channel-width direction. The 7^{th} and 8^{th} grooves G7-G8 with the gate inner spacer 200 therein may be extended along the 2^{nd} isolation structure 250-2 in the channel length direction, according to an embodiment. Among the 7^{th} and 8^{th} grooves G7-G8, the 8^{th} groove G8 may be connected to the 3^{rd} and the 4^{th} grooves G3-G4 extended in the channel-width direction, and thus, the gate inner spacer 200 therein may also be connected to one another, according to an embodiment.

According to an embodiment, when the lower channel structure 210 and the upper channel structure 220 have an equal channel width, and thus, the non-overlapping region may not exist in the multi-stack semiconductor device 20, the 1^{st} to 6^{th} grooves G1-G6 may not be formed in the multi-stack semiconductor device 20 while the 7^{th} and 8^{th} grooves G7-G8 may still be formed at the same positions shown in FIG. 8C.

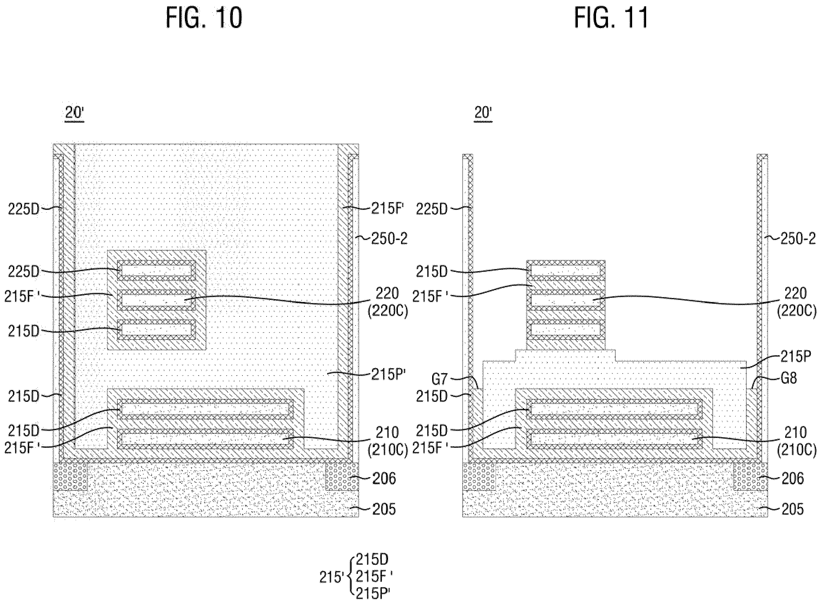

The gate inner spacer 200 included in the 1^{st} to 8^{th} grooves G1-G8 may be used to better protect the lower work-function metal layer 215F in a step of forming the upper work-function metal layer 225F in the multi-stack semiconductor device 20, and may remain therein after completion of the multi-stack semiconductor device 20, as will be further described in reference to FIGS. 10-14. Similar to the lower inner spacer 217 and the upper inner spacer 227, the gate inner spacer 200 may be formed of one or more materials including silicon nitride, silicon oxide, silicon oxynitride, silicon oxycarbide, silicon boron carbonitride, silicon oxy carbonitride, etc. not being limited.

FIG. 8C further shows that the gate dielectric layer 215D, the lower work-function metal layer 215F, and the gate inner spacer 200 in each of the 7^{th} and 8^{th} grooves G7-G8 on lower sidewalls of the 2^{nd} isolation structure 250-2 may be laterally interposed between the lower gate electrode 215P and the lower sidewalls of the 2^{nd} isolation structure 250-2.

Referring back to FIG. 8B, the lower gate electrode 215P may also be formed between the adjacent 1^{st} and 2^{nd} grooves G1-G2 with the gate inner spacer 200 therein, between the adjacent 3^{rd} and 4^{th} grooves G3-G4 with the gate inner spacer 200 therein, and between the adjacent 5^{th} and 6^{th} grooves G5-G6 with the gate inner spacer 200 therein. This is because, as will be further described in reference to FIGS. 10-14, the 1^{st} to 6^{th} grooves G1-G6 may be formed at both sides of the lower gate electrode 215P at these positions above the lower work-function metal layer 215F in the non-overlapping region due to the etch rate difference between the lower work-function metal layer 215F and the lower gate electrode 215P.

Thus, although a manufacturing process may include additional steps for the grooves and the gate inner spacer 200, the multi-stack semiconductor device 20 in the present embodiment may provide a better protection to the lower work-function metal layer 215F in the process of manufacturing a multi-stack semiconductor device having different work-function metal layers for a lower nanosheet transistor and an upper nanosheet transistor.

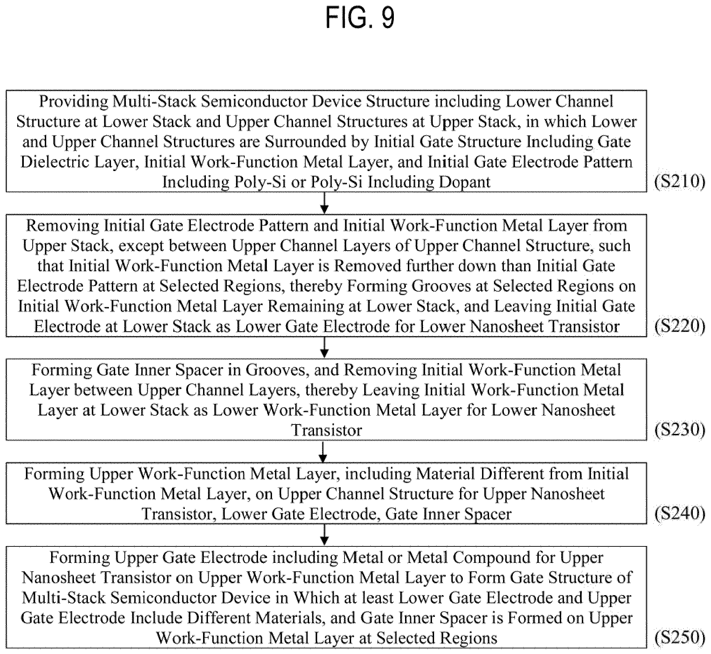

Herebelow, a method of manufacturing a multi-stack semiconductor device corresponding to the multi-stack semiconductor device 20 shown in in FIGS. 8A-8D is described in reference to FIGS. 9-14.

FIG. 9 is a flowchart of a method of manufacturing a multi-stack semiconductor device in which a lower gate electrode for a lower nanosheet transistor is formed of poly-Si and includes a gate inner spacer protecting a lower work-function metal layer for a lower gate structure, according to an embodiment. FIGS. 10-14 illustrate multi-stack semiconductor device structures in channel-width direction views after respective steps of a method of manufacturing the multi-stack semiconductor device referred to in the flowchart of FIG. 9, according to an embodiment. It is understood that the method of manufacturing the multi-stack semiconductor device is described in reference to channel-width direction views, for brevity purposes.

The multi-stack semiconductor device structures shown in FIGS. 10-14 may be the same as or correspond to the multi-stack semiconductor device 20 shown in FIGS. 8A-8D. Thus, duplicate descriptions the same or corresponding structures or elements may be omitted herebelow. The same reference numbers and reference characters used for describing the multi-stack semiconductor device 20 in FIGS. 8A-8D may be used herebelow when the same structures or elements are referred to.

In step S210 of FIG. 9, a multi-stack semiconductor device structure including a lower channel structure at a lower stack and an upper channel structures at an upper stack may be provided, in which the lower channel structure and the upper channel structure are surrounded by an initial gate structure including a gate dielectric layer, an initial work-function metal layer, and an initial gate electrode pattern including poly-Si or poly-Si including a dopant.

Referring to FIG. 10, a multi-stack semiconductor device structure 20' including the lower channel structure 210 at a lower stack and the upper channel structure 220 at an upper stack may be provided on the substrate 205. The two channel structures 210 and 220 may be surrounded by an initial gate structure 215'. Since this multi-stack semiconductor device structure 20' may be the same as the multi-stack semiconductor device structure 10' shown in FIG. 2, and thus, the initial gate structure 215' of FIG. 8 that includes the gate dielectric layer 215D, an initial work-function metal layer 215F' and an initial gate electrode pattern 215P' may be the same as or similar to the initial gate structure 115' of FIG. 2 that includes the gate dielectric layer 115D, the initial work-function metal layer 115F' and the initial gate electrode pattern 115P'. Accordingly, duplicate descriptions are omitted herein.

In step S220 of FIG. 9, the initial gate electrode pattern and the initial work-function metal layer are removed from the upper stack, except between upper channel layers of the upper channel structure, such that the initial work-function metal layer is removed further down than the initial gate electrode pattern at selected regions, thereby forming a plurality of grooves at the selected regions on the initial work-function metal layer remaining at the lower stack, and leaving the initial gate electrode at the lower stack as a lower gate electrode for a lower nanosheet transistor.

Referring to FIG. 11, the initial gate electrode pattern 215P' and the initial work-function metal layer 215F' may be removed from the upper stack of the multi-stack semiconductor device structure 20', except between the upper channel layers 220C and between a lowermost one of the upper channel layers 220C and the initial gate electrode pattern 215P', based on different etch rates or etch selectivity between poly-Si or poly-Si including a dopant and a metal or a metal compound, according to an embodiment.

The removal operation in this step may be performed through, for example, photolithography and dry etching such as reactive ion etching (RIE) to remove the initial gate electrode pattern 215P', which is formed of poly-Si or poly-Si including a dopant, and the initial work-function metal layer 215F' to a level around between the two channel structures 210 and 220 without affecting other semiconductor elements including the gate dielectric layer 215D. For example, a combination of a hydrogen bromide (HBr) gas and a fluorinated gas mixed with oxygen may be used for an RIE etchant, not being limited thereto. Although not shown, the upper channel structure 220 with a mask pattern thereon may be used as a mask structure for the photolithography and dry etching operation. Thus, after the removal operation in this step, the gate dielectric layer 215D may still remain at the upper stack of the multi-stack semiconductor device structure 20'. Further, due to the dry etching performed in this step, the initial work-function metal layer 215F' formed between the upper channel layers 220C and between the lowermost upper channel layer 220C and the initial gate electrode pattern 215P' may also remain in the multi-stack semiconductor device structure 20'.

Moreover, when the reactive ion etching (RIE) having a higher etch rate for the material(s) forming the initial work-function metal layer 215F' than for the material(s) forming the initial gate electrode pattern 215P' is applied in this step, the initial work-function metal layer 215F' may be etched down further than the initial gate electrode pattern 215P'. As a result, a plurality of grooves including the 1^{st} to 8^{th} grooves G1-G8 (shown in FIGS. 8A-8D and 11) may be formed at the sides of the initial gate electrode pattern 215P' remaining at or below the level between the lower channel structure 210 and the upper channel structure 220. The grooves G1-G8 may be formed on the initial work-function metal layer 215F' at the lower stack, and thus, a bottom of each of the grooves G1-G8 may be a top surface of the remaining initial work-function metal layer 215F' at that position. A height of the grooves G1-G8 may correspond to the etch rate difference between the material(s) of the initial gate electrode pattern 215P' and the material(s) of the initial work-function metal layer 215F'. As described above, the initial gate electrode pattern 215P' may include poly-Si or poly-Si in which a dopant is included, and the initial work-function metal layer 215F' may include titanium (Ti), tantalum (Ta) or their compound such as TiN, TiAl, TiAlN, TaN, TiC, TaC, TiAlC, TaCN, TaSiN, not being limited thereto.

The 1^{st} to 8^{th} grooves G1-G8 may be formed on the initial work-function metal layer 215F' remaining after the dry etching at the non-overlapping region as described above in reference to FIGS. 1A-1D and 8A-8D. Each of the 1^{st} to 6^{th} grooves G1-G6 may be extended in the channel-width direction with a portion of the initial gate electrode pattern 215P' which remains after the dry etching (FIGS. 8A-8B). Further, the 7^{th} and 8^{th} grooves G7-G8 which may be extended in the channel-length direction may be formed on the remaining initial work-function metal layer 215F' between the remaining initial gate electrode pattern 215P' and the 2^{nd} isolation structure 150-2 (FIGS. 8C and 11).

Among the 1^{st} to 8^{th} grooves G1-G8, the 1^{st} to 6^{th} grooves G1-G6 may be formed due to the channel-width difference between the lower channel structure 210 and the upper channel structure 220 as discussed above. Thus, when the lower channel structure 210 and the upper channel structure 220 have an equal channel width, and thus, the multi-stack semiconductor device structure 20' does not have the non-overlapping region, the 1^{st} to 6^{th} grooves G1-G6 may not be formed by the photolithography and dry etching operation in this step, while the 7^{th} and 8^{th} grooves G7-G8 may still be formed at the same positions shown in FIG. 11.

The initial gate electrode pattern 215P' remaining after the removal operation in this step may form the lower gate electrode 215P of the multi-stack semiconductor device 20 of FIGS. 8A-8D.

In step S230 of FIG. 9, a gate inner spacer may be formed in the grooves, and the initial work-function metal layer between the upper channel layers may be removed, thereby leaving the initial work-function metal layer at the lower stack as a lower work-function metal layer for the lower nanosheet transistor.

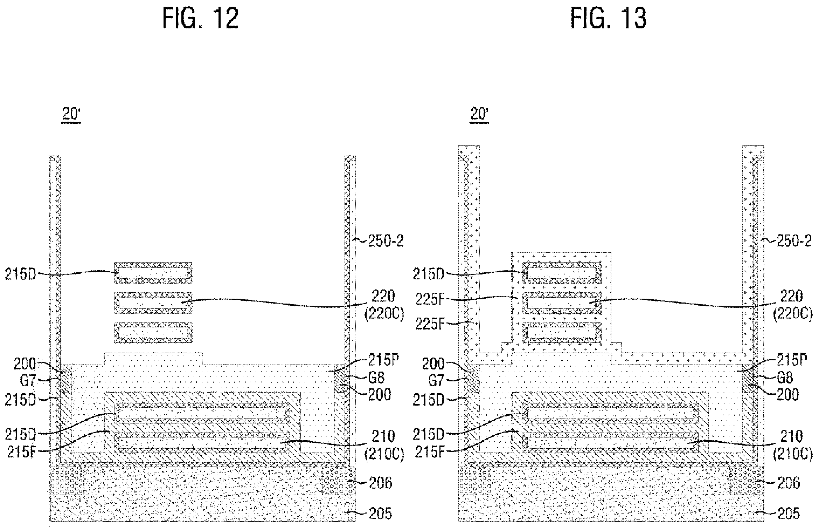

Referring to FIG. 12, the gate inner spacer 200 may be formed in the grooves including the 1^{st} to 8^{th} grooves G1-G8, and the initial work-function metal layer 115F' remaining between upper channel layers 220C and between the lowermost upper channel layer 220C and the lower gate electrode 215P after the dry etching in the previous step may be removed while the gate inner spacer 200 protects the initial work-function metal layer 115F' therebelow.

The gate inner spacer 200 may be formed in the grooves through, for example, a thin film deposition technique such as atomic layer deposition (ALD). The gate inner spacer 200 may include one or more materials of silicon nitride, silicon oxide, silicon oxynitride, silicon oxycarbide, silicon boron carbonitride, silicon oxy carbonitride, etc. not being limited thereto. Although not shown in the drawings, the gate inner spacer 200 may be formed by depositing the above inner spacer material(s) on the multi-stack semiconductor device structure 20' exposing the grooves through ALD, and pinching off the inner spacer material(s) formed in the grooves through, for example, wet etching using hydrofluoric acid (HF) or a mixture of hydrofluoric and nitric acid as wet etchant, not being limited thereto. This wet etching may selectively etch the material(s) forming the gate inner spacer 200. Through this deposition and etching operation, the gate inner spacer 200 may be pinched off to remain in the grooves, according to an embodiment. As the gate inner spacer 200 is pinched off, a top surface of the gate inner spacer 200 in the grooves may be coplanar with the top surface of the initial gate electrode 215P, according to an embodiment.

While the gate inner spacer 200 in the grooves formed in the non-overlapping region covers or protects the initial work-function metal layer 215F' therebelow, the initial work-function metal layer 215F' remaining between upper channel layers 220C at the upper stack after the previous dry etching operation may be removed through, for example, wet etching using a wet etchant including hydrogen peroxide, not being limited thereto, that may selectively attack the material(s), such as TiN or TiC, forming the initial work-function metal layer 215F' against poly-Si or poly-Si including a dopant forming the initial gate electrode 215P and the material(s) such as silicon nitride forming the gate inner spacer 200. Thus, the initial work-function metal layer 215F' may remain only at the lower stack to form the lower work-function metal layer 215F of the multi-stack semiconductor device 20 shown in FIGS. 8A-8D.

Unless the grooves are formed and the gate inner spacer 200 is formed therein, there may still exist a risk of the wet etchant for removing the initial work-function metal layer 215F' remaining between the upper channel layers 220C may also attack the initial work-function metal layer 215F' of the initial gate structure 215'. In other words, by forming the grooves and the gate inner spacer 200 therein, the initial work-function metal layer 215F' of the initial gate structure 215' may be protected when the initial work-function metal layer 215F' remaining between the upper channel layers 220C is removed in this step.

In step S240 of FIG. 9, an upper work-function metal layer, including a material different from the initial work-function metal layer, may be formed on the upper channel structure for an upper nanosheet transistor, the lower gate electrode, and the gate inner spacer.

Referring to FIG. 13, an upper work-function metal layer 225F may be formed on a place where the initial work-function metal layer 215F' above the level between the two channel structures 110 and 120 is removed, according to an embodiment. Here, the upper work-function metal layer 225F may be formed of a material(s) different from a material(s) forming the initial work-function metal layer 215F', according to an embodiment.

In this step, the upper-function metal layer 225F replacing the initial work-function metal layer 215F' removed in the previous step may be formed through, for example, atomic layer deposition (ALD), not being limited thereto. The upper work-function metal layer 225F may be conformally formed to surround the upper channel layers 220C. The upper work-function metal layer 225F may also be formed on the top surface of the lower gate electrode 215P, extended out to the 1^{st} isolation structure 250-1 (shown in FIGS. 8A-8B) and the 2^{nd} isolation structure 250-2. Further, the upper work-function metal layer 225F may be formed on the sidewalls and the top surfaces of the isolation structure 250-1, 250-2 and the ILD structure 260 (shown in FIGS. 8A-8B) with the gate dielectric layer 215D therebetween.

In step S250, an upper gate electrode including a metal or a metal compound for an upper nanosheet transistor may be formed on the upper work-function metal layer to form a gate structure of a multi-stack semiconductor device in which at least the lower gate electrode and the upper gate electrode include different materials, and a gate inner spacer is formed on the upper work-function metal layer at the selected regions.

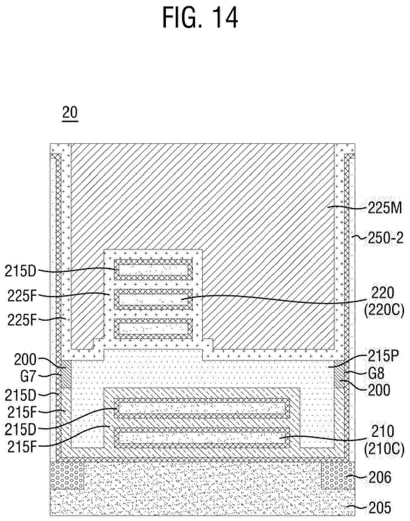

Referring to FIG. 14, the upper gate electrode 225M may be formed on the upper work-function metal layer 225F and planarized to complete the gate structure of the multi-stack semiconductor device 20 shown in FIGS. 8A-8D, according to an embodiment.

The upper gate electrode 225M may be deposited through, for example, physical vapor deposition (PVD), chemical vapor deposition (CVD), plasma enhanced chemical vapor deposition (PECVD), or combinations thereof, not being limited thereto. The planarization of the upper gate electrode 225M may be performed through, for example, a chemical mechanical planarization (CMP) technique, not being limited thereto, so that a top surface of the upper gate electrode 225M may be coplanar with the upper work-function metal layer 225F formed on the top surfaces of the isolation structure 250-1, 250-2 and the ILD structure 260.

Through the above steps, the multi-stack semiconductor device 20 in which the lower gate electrode 215P may be formed of more cost-effective poly-Si or poly-Si including a dopant while the upper gate electrode 225M may be formed of a metal or a metal compound. Further, the multi-stack semiconductor device 20 may include the gate inner spacer 200 formed at the selected regions including the sides of the lower gate electrode 215P to better protect the initial work-function metal layer 215F' at the lower stack, which would become the lower work-function metal layer 215F, from being etched or damages in the process of manufacturing the multi-stack semiconductor device 20.

In the above embodiments of a multi-stack semiconductor device including a lower nanosheet transistor and an upper nanosheet transistor, poly-Si or poly-Si including a dopant instead of a metal or a metal compound is used to form a lower gate electrode for the lower nanosheet transistor for the purposes of cost-effectiveness, manufacturing simplicity and protection of a lower work-function metal layer. However, the metal or metal compound may still be preferred as a material(s) for a gate electrode at least because the metal or metal compound has a lower gate resistance than poly-Si or poly-Si including a dopant. Thus, the following embodiments provide a multi-stack semiconductor device in which a poly-Si layer is formed between a lower gate structure and an upper gate structure to protect a lower work-function metal layer in a process of manufacturing the multi-stack semiconductor device, while a lower gate electrode and an upper gate electrode are both formed of a metal or a metal compound.

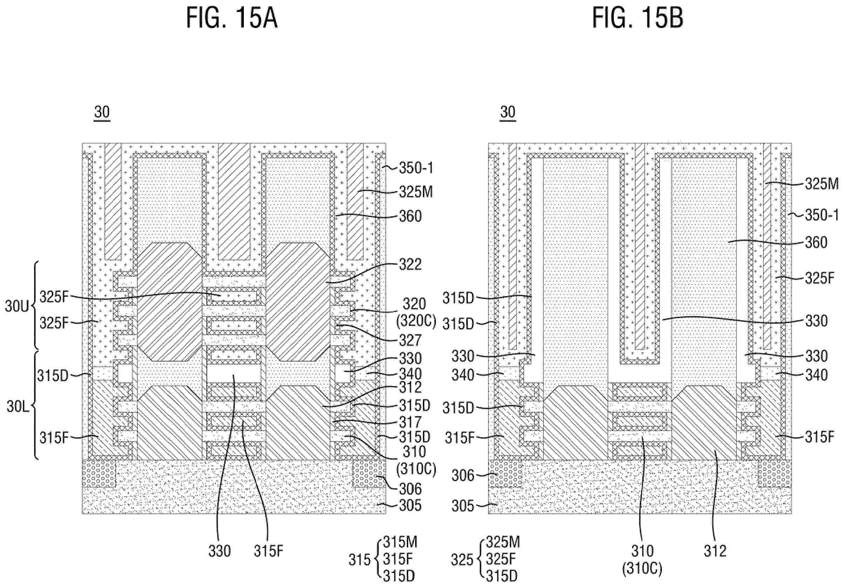

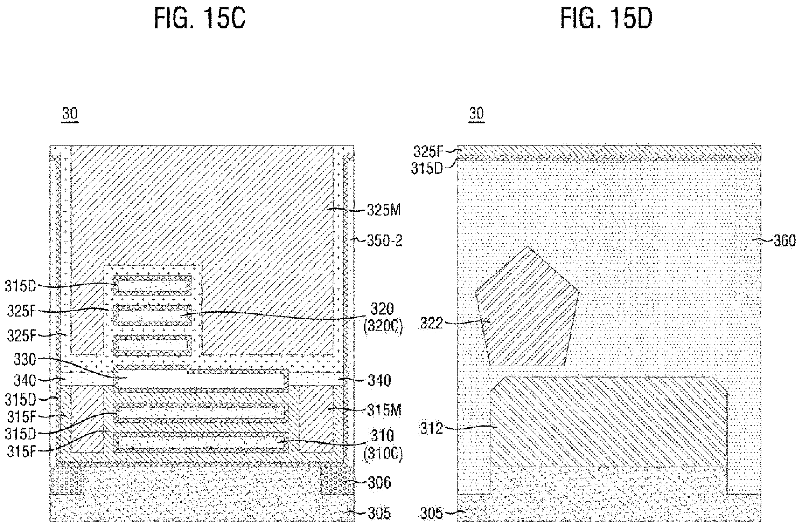

FIGS. 15A-15D illustrate a multi-stack semiconductor device in which a poly-Si layer is formed between a lower gate structure and an upper gate structure , according to an embodiment.

Referring to FIGS. 15A-15D, a multi-stack semiconductor device 30 may include a lower nanosheet transistor 30L and an upper nanosheet transistor 30U formed on the substrate 305, and an STI structure 306 may also be formed on the substrate 305.

Various structures and elements forming the multi-stack semiconductor device 30 may be the same or similar to those of the multi-stack semiconductor device 10 as shown in FIGS. 1A-1D in terms of their structural, functional and material characteristics. For example, in the multi-stack semiconductor device 30, a lower channel structure 310 including lower channel layers 310C, lower source/drain regions 312, a lower inner spacer 317, an upper channel structure 320 including upper channel layers 320C, an upper gate structure 325 including an upper portion of a gate dielectric layer 315D, an upper work-function metal layer 325F and an upper gate electrode 325M, upper source/drain regions 322, an upper inner spacer 327, a 1^{st} isolation structure 350-1, a 2^{nd} isolation structure 350-2 and an ILD structure 360 may be the same as or similar to the corresponding structures or elements in the multi-stack semiconductor device 10. In addition, the upper channel structure 320 may have a shorter channel width than the lower channel structure 310 as in the multi-stack semiconductor device 10. Thus, duplicate descriptions thereof are omitted, and only different aspects of the multi-stack semiconductor device 30 are described herebelow.

Referring to FIGS. 15A-15C, in the multi-stack semiconductor device 30, the upper gate structure 325 is separated from a lower gate structure 315 by an isolation layer 330 which may be formed of, for example, silicon nitride, not being limited thereto. Similar to the lower gate structure 115 of the multi-stack semiconductor device 10, the lower gate structure 315 may include a lower portion of a gate dielectric layer 315D surrounding the lower channel layers 310C, a lower work-function metal layer 315F formed thereon, and a lower gate electrode 315M formed on the lower work-function metal layer 315F. Like the gate dielectric layer 115D in the multi-stack semiconductor device 10, the gate dielectric layer 315D may also be formed on the substrate 305, the STI structure 306 and sidewalls and top surfaces of the 1^{st} isolation structure 350-1, the 2^{nd} isolation structure 350-2, and the ILD structure 360.

However, unlike in the multi-stack semiconductor device 10, the gate dielectric layer 315D in the multi-stack semiconductor device 30 may also surround the isolation layer 330, and the lower work-function metal layer 315F may also be formed between an uppermost one of the lower channel layers 315C and the isolation layer 330 with the gate dielectric layer 315D therebetween.

Further, according to an embodiment, the lower gate electrode 315M may be formed of a metal such as copper (Cu), aluminum (Al), tungsten (W), molybdenum (Mo), ruthenium (Ru), cobalt (Co), or their compound, not being limited thereto.

In addition, according to an embodiment, a poly-Si layer 340 may be formed on top surfaces of the lower gate electrode 315M and portions of the lower work-function metal layer 315F on the lower gate electrode 315M. Further, according to an embodiment, the upper work-function metal layer 325F laterally extended to the 1^{st} isolation structure 350-1 and the 2^{nd} isolation structure 350-2 may be formed on a top surface of the poly-Si layer 340 so that the poly-Si layer 340 can electrically connect the lower gate structure 315 with the upper gate structure 325 by which the two gate structures 315 and 325 may share a gate input signal.

Due to its crystalline metallurgical structure, poly-Si may be still used as a conducting gate electrode material, and thus, the poly-Si layer 340 formed on the lower gate electrode 315M may be able to electrically connect the two gate structures 315 and 325. Further, the poly-Si layer 340 may also be doped or implanted with one or more dopants such as boron (B), gallium (Ga), phosphorous (As), arsenic (Sb), indium (In), etc. to enhance conductor attributes in the poly-Si layer 340, according to an embodiment.

The poly-Si layer 340 may be formed such that a top surface thereof is at the same level as or below a level of a top surface of the isolation layer 330, and a bottom surface thereof is at the same level as or above a level of a bottom surface of the isolation layer 330, according to an embodiment. Further, the poly-Si layer 340 formed on the top surface of the lower gate electrode 315M may be laterally interposed between the isolation layer 330 and the 1^{st} isolation structure 350-1 and between the poly-Si layer 340 and the 2^{nd} isolation structure 350-2.

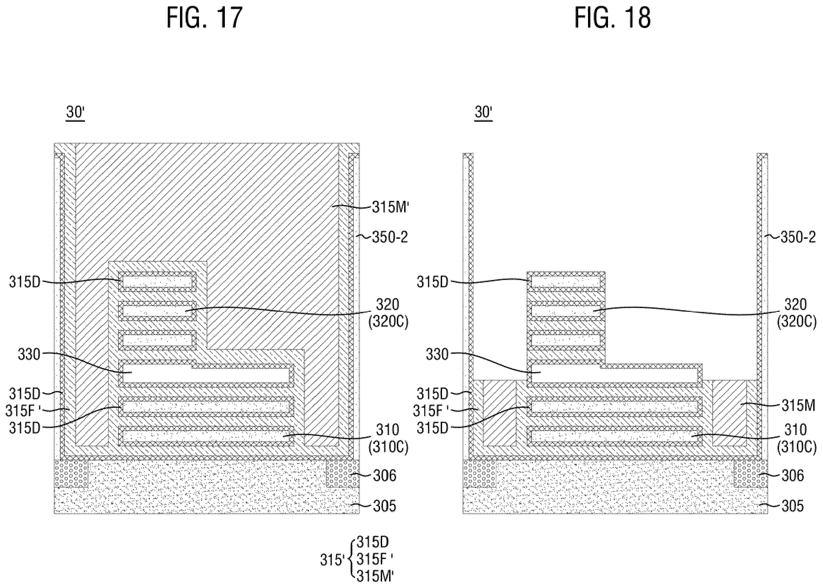

The poly-Si layer 340 may be used for protecting a work-function metal layer formed on a lower stack of a multi-stack semiconductor device structure in the manufacturing process of the multi-stack semiconductor device 30, as will be described later in reference to FIGS. 17-22. This poly-Si layer 340 may remain in the completed multi-stack semiconductor device 30, and used as part of a lower gate electrode of the lower nanosheet transistor 30L.

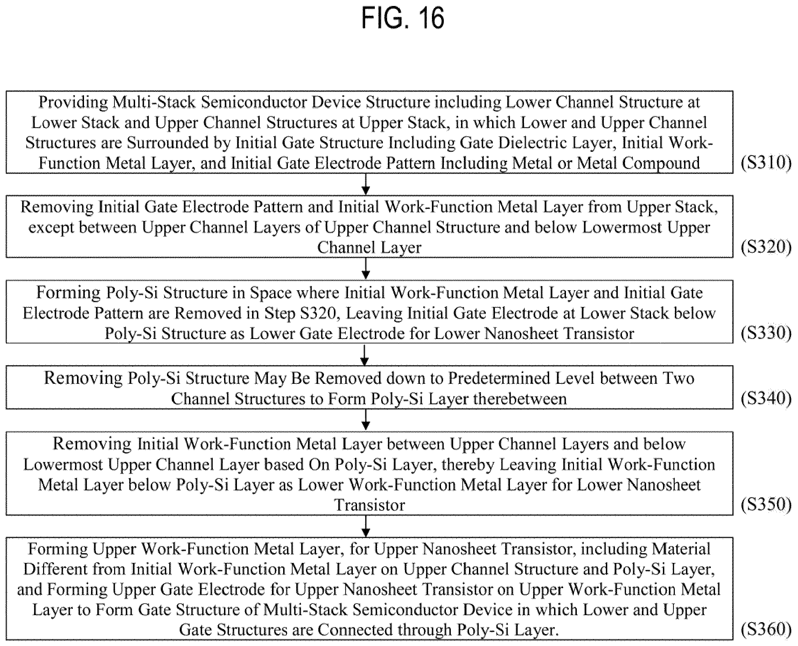

Herebelow, a method of manufacturing a multi-stack semiconductor device corresponding to the multi-stack semiconductor device 30 shown in FIGS. 15A-15D is described in reference to FIGS. 16-22.

FIG. 16 is a flowchart of a method of manufacturing a multi-stack semiconductor device in which a poly-Si layer is formed between a lower gate structure and an upper gate structure, and a lower gate electrode and an upper gate electrode are both formed of a metal or a metal compound, according to an embodiment. FIGS. 17-22 illustrate multi-stack semiconductor device structures in channel-width direction views after respective steps of a method of manufacturing the multi-stack semiconductor device referred to in the flowchart of FIG. 16, according to an embodiment. It is understood that the method of manufacturing the multi-stack semiconductor device is described in reference to channel-width direction views for brevity purposes.

The multi-stack semiconductor device structures shown in FIGS. 17-22 may be the same as or correspond to the multi-stack semiconductor device 40 shown in FIGS. 15A-15D. Thus, duplicate descriptions the same or corresponding structures or elements may be omitted herebelow. The same reference numbers and reference characters used for describing the multi-stack semiconductor device 30 in FIGS. 15A-15D may be used herebelow when the same structures or elements are referred to.

In step S310 of FIG. 16, a multi-stack semiconductor device structure including a lower channel structure at a lower stack and an upper channel structures at an upper stack may be provided, in which the lower channel structure and the upper channel structure are surrounded by an initial gate structure including a gate dielectric layer, an initial work-function metal layer, and an initial gate electrode pattern including a metal or a metal compound.

Referring to FIG. 17, a multi-stack semiconductor device structure 30' including the lower channel structure 310 at a lower stack and the upper channel structure 320 at an upper stack may be provided on the substrate 305. The two channel structures may be surrounded by an initial gate structure 315'. Each of lower channel structure 310 and the upper channel structure 320 may be formed of a plurality of nanosheet layers as channel layers, according to an embodiment. The nanosheet layers of the channel structures 310 and 320 may have been epitaxially grown from the substrate 305.

Like in the multi-stack semiconductor device structure 10' shown in FIG. 2, the upper channel structure 320 may have a smaller channel width than the lower channel structure 310. Accordingly, the upper source/drain regions 322 grown from the upper channel structure 320 may have a smaller width than the lower source/drain regions 312 grown from the lower channel structure 110 (as shown in FIGS. 1A-1D). This channel-width difference and the source/drain region-width difference may be provided to facilitate connection of a source/drain contact structure on a top surface of the lower source/drain regions 312, as described above in the previous embodiments.

The initial gate structure 315' of the multi-stack semiconductor device structure 30' may include the gate dielectric layer 315D, an initial work-function metal layer 315F' and an initial gate electrode pattern 315M'. The gate dielectric layer 315D' with the initial work-function metal layer 315F' thereon may surround both the lower channel layers 310C of the lower channel structure 310 and the upper channel layers 320C of the upper channel structure 320. The initial gate electrode pattern 315M' may be patterned to be formed on the initial work-function metal layer 315F'. Here, the initial gate electrode pattern 315M', which is to form the lower gate electrode 315M of the multi-stack semiconductor device 30 shown in FIGS. 1A-1D in a later step, may be formed of a metal such as copper (Cu), aluminum (Al), tungsten (W), molybdenum (Mo), ruthenium (Ru), cobalt (Co), or their compound, not being limited thereto, according to an embodiment.

The gate dielectric layer 315D' and the initial work-function metal layer 315F' thereon may be also laterally extended on the substrate 305 and the STI structure 306 to the 1^{st} isolation structure 350-1 (as shown in FIGS. 15A-15B) and the 2^{nd} isolation structure 350-2. The laterally extended gate dielectric layer 315D' and initial work-function metal layer 315F' thereon may also be extended upward along the sidewalls of the two isolation structures 350-1 and 350-2 and may also be formed on the top surfaces thereof. The gate dielectric layer 315D' and the initial work-function metal layer 315F' thereon may also be formed on the sidewalls and the top surface of the ILD structure 360 (as shown in FIGS. 15A-15D) .

According to an embodiment, the isolation layer 330 may be formed between the lower channel structure 310 and the upper channel structure 320, and surrounded by the gate dielectric layer 315D and the initial work-function metal layer 315F'. Although not shown, the isolation layer 330 may have replaced a silicon-germanium layer interposed between the two channel structures 310 and 320 that were epitaxially grown along with the channel layers 310C and 320C from the substrate 305.

In step S320 of FIG. 16, the initial gate electrode pattern and the initial work-function metal layer may be removed from the upper stack, except between upper channel layers of the upper channel structure and below a lowermost one of the upper channel layers.

Referring to FIG. 18, the initial gate electrode pattern 315M' and the initial work-function metal layer 315F' may be removed from the upper stack of the multi-stack semiconductor device structure 30' except between the upper channel layers 320C and between the lowermost one of the upper channel layers 320C and the isolation layer 330, according to an embodiment.

The removal operation in this step may be performed through, for example, photolithography and dry etching such as reactive ion etching (RIE) to selectively remove the initial gate electrode pattern 315M' and the initial work-function metal layer 315F' down to a level of or a level below the bottom surface of the isolation layer 330 or to a level between the bottom surface and the top surface of the isolation layer 330, according to an embodiment. For example, fluorinated gas plasma mixed with oxygen may be used for an RIE etchant, not being limited thereto. Although not shown, the upper channel structure 320 with a mask pattern thereon may be used as a mask structure for a photolithography and dry etching operation. Thus, after the removal operation in this step, the initial work-function metal layer 315F' formed between the upper channel layer 320C and between the lowermost one of the upper channel layers 320C and the isolation layer 330 may still remain at the upper stack of the multi-stack semiconductor device structure 30'. The gate dielectric layer 315D may also survive the removal operation in this step.

In step S330 of FIG. 16, a poly-Si structure may be formed in a space where the initial work-function metal layer and the initial gate electrode pattern are removed in step S320, leaving the initial gate electrode at the lower stack below the poly-Si structure as a lower gate electrode for a lower nanosheet transistor.

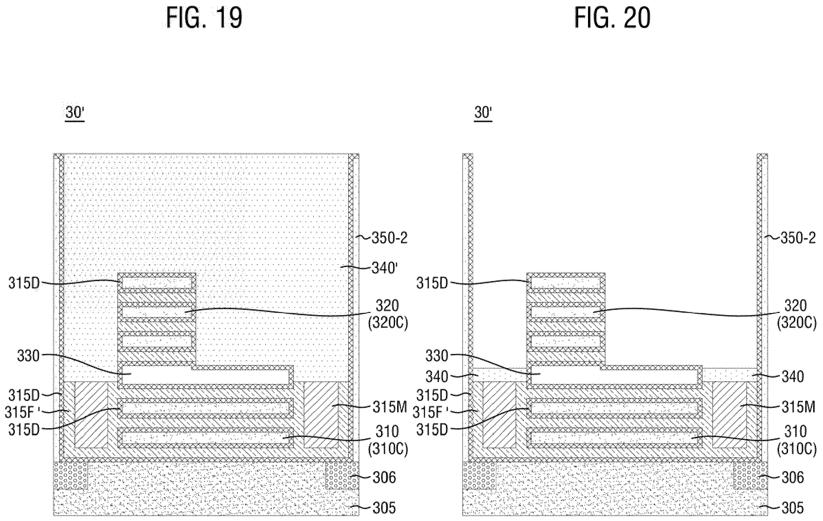

Referring to FIG. 19, a poly-Si structure 340' may be formed in a space where the initial gate electrode pattern 315M' and the initial work-function metal layer 315F' are removed, and planarized, according to an embodiment.

In this step, the formation of the poly-Si structure 340' may be performed through, for example, physical vapor deposition (PVD), chemical vapor deposition (CVD), plasma enhanced chemical vapor deposition (PECVD), or combinations thereof, not being limited thereto. The planarization of the poly-Si structure 340' may be performed through, for example, a chemical mechanical planarization (CMP) technique, not being limited thereto, so that a top surface of the poly-Si structure 340' may be coplanar with the top surfaces of the isolation structure 350-1, 350-2 and the ILD structure 360.

According to an embodiment, the poly-Si structure 340' may be formed on a top surface of the initial gate electrode 315M, and further, the poly-Si structure 340' may also cover a top surface of the initial work-function metal layer 315F' remaining and exposed upward after the removal operation in the previous step.

The initial gate electrode pattern 315M' remaining below the poly-Si structure 340' in this step forms the lower gate electrode 315M of the multi-stack semiconductor device 30.

In step S340 of FIG. 16, the poly-Si structure may be removed down to a predetermined level between the two channel structures to form a poly-Si layer therebetween.

Referring to FIG. 20, the poly-Si structure 340' may be removed down to a level of or below the top surface of the isolation layer 330 to form the poly-Si layer 340 on the lower gate electrode 315M and the lower work-function metal layer 315F at a side of the lower channel structure 310, according to an embodiment.

Although not shown, the operation of removing the poly-Si structure 340' in this step may be performed through, for example, another photolithography and dry etching based on the upper channel structure 320 with a mask pattern thereon again.

According to an embodiment, the removal operation may be performed such that a top surface of the poly-Si structure 340' remaining after the removal operation may be at the level of or below the top surface of the isolation layer 330 to form the poly-Si layer 340 on the lower gate electrode 315M.

Further, in this step, the poly-Si layer 340 may be doped or implanted with one or more dopants such as boron (B), gallium (Ga), phosphorous (As), arsenic (Sb), indium (In), etc., according to an embodiment. Alternatively, the doping or implantation operation may be performed on the poly-Si structure 340' before this poly-Si structure 340' is removed to leave only the poly-Si layer 340 in the previous step, according to an embodiment.

In step S350 of FIG. 16, the initial work-function metal layer between the upper channel layers and below the lowermost one of the upper channel layers may be removed based on the poly-Si layer, thereby leaving the initial work-function metal layer below the poly-Si layer as a lower work-function metal layer for the lower nanosheet transistor.

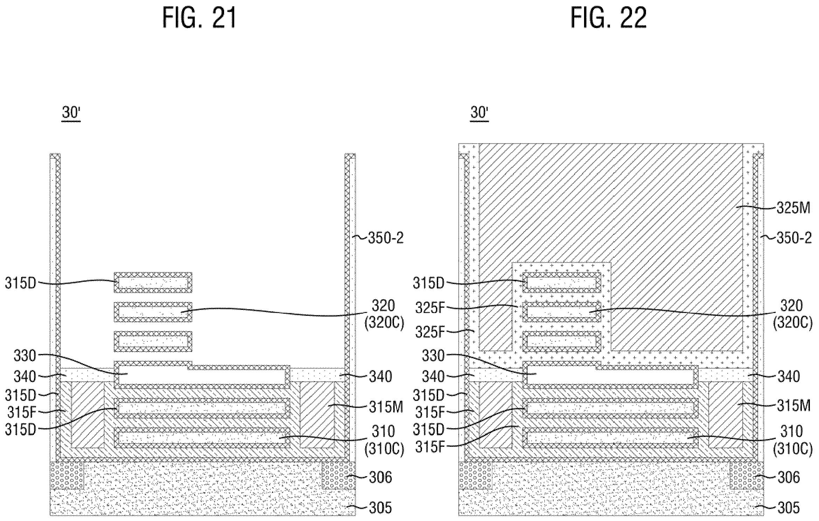

Referring to FIG. 21, the initial work-function metal layer 315F' remaining between the upper channel layers 320C and between the lowermost one of the upper channel layers 320C and the isolation layer 330 may be removed, according to an embodiment.

In this step, the initial work-function metal layer 315F' may be removed through, for example, wet etching using a wet etchant including hydrogen peroxide, not being limited thereto that may selectively attack the material(s), such as TiN or TiC, forming the initial work-function metal layer 315F' against poly-Si or poly-Si including a dopant which is included in the poly-Si layer 340 and the gate dielectric layer 315D. Thus, the initial work-function metal layer 315F' formed below the poly-Si layer 340 may be prevented from being etched or damaged.

After the removal operation of the initial work-function metal layer 315F' in the upper stack of the multi-stack semiconductor device structure 30', the initial work-function metal layer 315F' remaining in the lower stack of the multi-stack semiconductor device structure 30' becomes the lower work-function metal layer 315F for the multi-stack semiconductor device 30.

Alternatively and/or additionally, before the initial work-function metal layer 315F' in the upper stack of the multi-stack semiconductor device structure 30' is removed, the poly-Si layer 340 may be further removed by etching a portion thereof on only on the lower gate electrode 315M, according to an embodiment, This further removal operation may leave at least a portion of the initial work-function metal layer 315F' on the initial work-function metal layer 315F' remaining and exposed upward at a distant side of lower channel structure 310 and the upper channel structure 320 after the removal operation in the previous step of FIG. 18, according to an embodiment. This alternative and/or additional step may reduce a higher gate resistance that may be generated from the poly-Si layer 340 because the poly-Si layer 340 may not be formed on the top surface of the lower gate electrode 310M while it may be formed on the remaining and exposed initial work-function metal layer 315F'.

In step S360 of FIG. 16, an upper work-function metal layer, for an upper nanosheet transistor, including a material different from the initial work-function metal layer may be formed on the upper channel structure and the poly-Si layer, and an upper gate electrode for the upper nanosheet transistor may be formed on the upper work-function metal layer to form a gate structure of a multi-stack semiconductor device in which the lower gate structure and the upper gate structure are connected through the poly-Si layer.

Referring to FIG. 22, the upper work-function metal layer 325F may be formed on a place where the initial work-function metal layer 315F' in the upper stack of the multi-stack semiconductor device structure 30' is removed, and the upper gate electrode 325M may be formed on the upper work-function metal layer 325F and planarized to complete the gate structure of the multi-stack semiconductor device 30 shown in FIGS. 15A-15D, according to an embodiment.

Here, the upper work-function metal layer 325F may include a material(s) which is different from a material(s) included in the initial work-function metal layer 315F', according to an embodiment.

In this step, the upper work-function metal layer 325F replacing the initial work-function metal layer 315F' removed from the upper stack of the multi-stack semiconductor device structure 30' in the previous step may be formed through, for example, atomic layer deposition (ALD), not being limited thereto. The upper work-function metal layer 325F may be conformally formed to surround the upper channel layers 320C. The upper work-function metal layer 325F may also be formed on the top surface of the poly-Si layer 340, and may also be formed on the sidewalls and the top surfaces of the isolation structure 350-1, 350-2 and the ILD structure 360 (shown in FIGS. 15A-15D) with the gate dielectric layer 315D therebetween.

The upper gate electrode 325M may be deposited through, for example, physical vapor deposition (PVD), chemical vapor deposition (CVD), plasma enhanced chemical vapor deposition (PECVD), or combinations thereof, not being limited thereto. The planarization of the upper gate electrode 325M may be performed through, for example, a chemical mechanical planarization (CMP) technique, not being limited thereto, so that a top surface of the upper gate electrode 325M may be coplanar with the top surface of the upper work-function metal layer 325F formed on the isolation structures 350-1, 350-2 and the ILD structure 360.

Through the above steps, the multi-stack semiconductor device 30, in which the poly-Si layer 340 is formed on the lower gate electrode 315M and the lower work-function metal layer at a side of the lower channel structure, may be obtained. Due to this poly-Si layer 340, the lower work-function metal layer 315F of the multi-stack semiconductor device 30 may be prevented from being damaged or etched in the process of manufacturing the multi-stack semiconductor device 30.

The disclosure has been presented in the above embodiments in which each of a lower field-effect transistor and an upper field-effect transistor in a multi-stack semiconductor devices is a nanosheet transistor. However, the disclosure may also apply to a multi-stack semiconductor device in which at least one of the lower field-effect transistor and the upper field-effect transistors is a fin field-effect transistor (FinFET) in one or more vertical fin structure as channel layers are surrounded by a gate structure and the other one is a nanosheet transistor, and a multi-stack semiconductor device in which each of the lower field-effect transistor and the upper field-effect transistor is a FinFET, according to embodiments.

Further, the disclosure has been presented in the above embodiments in which a multi-stack semiconductor device includes a lower channel structure and an upper channel structure having different channel widths. However, the disclosure may also apply to a multi-stack semiconductor device in which a lower channel structure and an upper channel structure having have an equal channel width.

Further, the disclosure has been presented in the above embodiments in which a multi-stack semiconductor device includes a lower channel structure and an upper channel structure, and the upper channel structure has a greater number of channel layers than the lower channel structure. However, the disclosure may also apply to a multi-stack semiconductor device in which the lower channel structure has a greater number of channel layers than the upper channel structure, or the lower channel structure has the same number of channel layers as the upper channel structure.

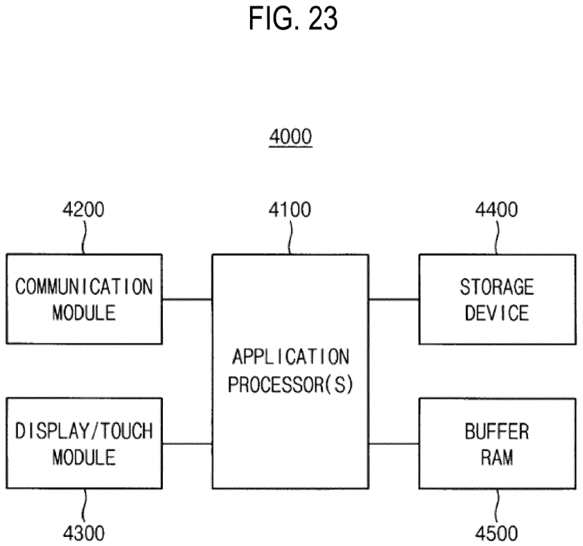

FIG. 23 is a schematic block diagram illustrating an electronic device including a multi-stack semiconductor device which may include a gate structure formed of a poly-Si or poly-Si including a dopant, according to an example embodiment.

Referring to FIG. 23, an electronic device 4000 may include at least one application processor 4100, a communication module 4200, a display/touch module 4300, a storage device 4400, and a buffer RAM 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

At least one component in the electronic device 4000 may include at least one of the multi-stack semiconductor devices 10, 20 and 30 described above in reference to FIGS. 1A-1E to FIG. 22.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A multi-stack semiconductor device comprising:
a substrate;
a lower field-effect transistor in which a lower channel structure is surrounded by a lower gate structure comprising a lower work-function metal layer and a lower gate electrode; and
an upper field-effect transistor in which an upper channel structure is surrounded by an upper gate structure comprising an upper work-function metal layer and an upper gate electrode,
wherein the lower gate electrode comprises polycrystalline silicon (poly-Si) or poly-Si comprising a dopant, and the upper gate electrode comprises a metal or a metal compound.

2. The multi-stack semiconductor device of claim 1, wherein the lower work-function metal layer and the upper work-function metal layer comprise different materials, respectively.

3. The multi-stack semiconductor device of claim 1 or 2, wherein a channel width of the upper channel structure is smaller than a channel width of the lower channel structure,
wherein each of the lower channel structure and the upper channel structure has one or more nanosheet channel layers, and
wherein the upper channel structure has a greater number of the nanosheet channel layers than the lower channel structure.

4. The multi-stack semiconductor device of any one of claims 1 to 3, further comprising a gate inner spacer which is formed between the lower work-function metal layer and the upper work-function metal layer at selected regions where the lower channel structure is not vertically overlapped by the upper channel structure.

5. The multi-stack semiconductor device of claim 4, wherein, at the selected regions, a top surface of the lower work-function metal layer below the gate inner spacer is lower than a level of a top surface of the lower gate electrode.

6. The multi-stack semiconductor device of claim 5, wherein the upper work-function metal layer is formed on the lower gate electrode, and connected to the lower gate electrode.

7. The multi-stack semiconductor device of any one of claims 1 to 6, wherein each of the lower channel structure and the upper channel structure has one or more nanosheet channel layers.

8. The multi-stack semiconductor device of claim 1 or 2, wherein the lower channel structure has one or more nanosheet channel layers for a nanosheet transistor, and the upper channel structure has one or more vertical fin structure as channel layers for a fin field-effect transistor.

9. The multi-stack semiconductor device of claim 1 or 2, further comprising a gate inner spacer which is formed between the lower work-function metal layer and the upper work-function metal layer at selected regions.

10. The multi-stack semiconductor device of claim 9, wherein, at the selected regions, a top surface of the lower work-function metal layer below the gate inner spacer is lower than a level of a top surface of the lower gate electrode.

11. The multi-stack semiconductor device of claim 9 or 10, wherein a channel width of the upper channel structure is smaller than a channel width of the lower channel structure,
wherein each of the lower channel structure and the upper channel structure has one or more nanosheet channel layers, and
wherein the upper channel structure has a greater number of the nanosheet channel layers than the lower channel structure.

12. The multi-stack semiconductor device of claim 10 or 11, wherein the selected regions comprise a side of the lower gate electrode when viewed in a channel-width direction where the gate inner spacer is not vertically overlapped by any of the lower channel structure and the upper channel structure.
